# EUROPEAN PATENT SPECIFICATION

(11) **EP 2 396 299 B1**
(45) Date of publication and mention of the grant of the patent: **24.07.2013**
(21) Application number: 10799193.7
(22) Date of filing: 16.12.2010
(51) Int. Cl.: G03F 7/00, G03F 7/004, C07C 381/12, B29C 67/00, G03F 7/038, G03F 7/027, B29C 35/08

(54) **LIQUID RADIATION CURABLE RESIN COMPOSITIONS FOR ADDITIVE FABRICATION COMPRISING A TRIARYL SULFONIUM BORATE CATIONIC PHOTOINITIATOR**
FLÜSSIGE STRAHLUNGSHÄRTBARE HARZZUSAMMENSETZUNGEN ZUR ADDITIVHERTSTELLUNG ENTHALTEND EINEN KATIONISCHEN TRIARYL-SULFONIUM-BORATE-FOTOINITIATOR
COMPOSITIONS DE RÉSINE LIQUIDES DURCISSABLES PAR RAYONNEMENT POUR FABRICATION ADDITIVE COMPRENANT UN PHOTOINITIATEUR CATIONIQUE DE TYPE BORATE DE TRIARYLSULFONIUM

(30) Priority: 17.12.2009 US 287620 P
(43) Date of publication of application: 21.12.2011
(73) Proprietor: DSM IP Assets B.V., 6411 TE Heerlen (NL)
(72) Inventor: SOUTHWELL, John, Edmund, Glen Ellyn, IL 60137 (US); XU, Jigeng, South Elgin, IL 60177-3264 (US); REN, Kangtai, Geneva, IL 60134 (US); DAKE, Ken, South Elgin, IL 60177 (US); EAST, Sam, Lake In The Hills, IL 60156 (US)
(74) Representative: Jansen, Cornelis Marinus
(86) International application number: PCT/US2010/060668
(87) International publication number: WO 2011/075553

(56) References cited:
- WO-A1-2007/118794
- WO-A1-2009/047151
- US-A- 5 468 902

## Description

### Field of the Invention

The present invention relates to liquid radiation curable resin compositions for additive fabrication processes.

### Background of the Invention

Additive fabrication processes for producing three dimensional objects are known in the field. Additive fabrication processes utilize computer-aided design (CAD) data of an object to build three-dimensional parts. These three-dimensional parts may be formed from liquid resins, powders, or other materials.

A non-limiting example of an additive fabrication process is stereolithography (SL). Stereolithography is a well-known process for rapidly producing models, prototypes, patterns, and production parts in certain applications. SL uses CAD data of an object wherein the data is transformed into thin cross-sections of a three-dimensional object. The data is loaded into a computer which controls a laser beam that traces the pattern of a cross section through a liquid radiation curable resin composition contained in a vat, solidifying a thin layer of the resin corresponding to the cross section. The solidified layer is recoated with resin and the laser beam traces another cross section to harden another layer of resin on top of the previous layer. The process is repeated layer by layer until the three-dimensional object is completed. When initially formed, the three-dimensional object is, in general, not fully cured and therefore may be subjected to post-curing, if required. An example of an SL process is described in U.S. Patent No. 4,575,330.

There are several types of lasers used in stereolithography, ranging from 193 nm to 355 nm in wavelength. The use of bulky and expensive gas lasers to cure liquid radiation curable resins is well known. The delivery of laser energy in a stereolithography system can be Continuous Wave (CW) or Q-switched pulses. CW lasers provide continuous laser energy and can be used in a high speed scanning process. However, their output power is limited which reduces the amount of curing that occurs during object creation. As a result the finished object will need additional post process curing. In addition, excess heat could be generated at the point of irradiation which may be detrimental to the resin. Further, the use of a laser requires scanning point by point on the resin which can be time-consuming.

Other methods of additive fabrication utilize lamps or light emitting diodes (LEDs). LEDs are semiconductor devices which utilize the phenomenon of electroluminescence to generate light. LEDs consist of a semiconducting material doped with impurities to create a p-n junction capable of emitting light as positive holes join with negative electrons when voltage is applied. The wavelength of emitted light is determined by the materials used in the active region of the semiconductor. Typical materials used in semiconductors of LEDs include, for example, elements from Groups 13 (III) and 15 (V) of the periodic table. These semiconductors are referred to as III-V semiconductors and include, for example, GaAs, GaP, GaAsP, AlGaAs, InGaAsP, AlGaInP, and InGaN semiconductors. Other examples of semiconductors used in LEDs include compounds from Group 14 (IV-IV semiconductor) and Group 12-16 (II-VI). The choice of materials is based on multiple factors including desired wavelength of emission, performance parameters, and cost.

Early LEDs used gallium arsenide (GaAs) to emit infrared (IR) radiation and low intensity red light. Advances in materials science have led to the development of LEDs capable of emitting light with higher intensity and shorter wavelengths, including other colors of visible light and UV light. It is possible to create LEDs that emit light across a wide wavelength spectrum, for example, from a low of about 100 nm to a high of about 900 nm. Typically, LED UV light sources currently emit light at wavelengths between 300 and 475 nm, with 365 nm, 390 nm, and 395 nm being common peak spectral outputs. See textbook, "Light-Emitting Diodes" by E. Fred Schubert, 2nd Edition, © E. Fred Schubert 2006, published by Cambridge University Press.

Several manufacturers offer LED lamps for commercial curing applications. For example, Phoseon Technology, Summit UV, Honle UV America, Inc., IST Metz GmbH, Jenton International Ltd., Lumos Solutions Ltd., Solid UV Inc., Seoul Optodevice Co., Ltd., Spectronics Corporation, Luminus Devices Inc., and Clearstone Technologies, are some of the manufacturers offering LED lamps for curing ink-jet printing compositions, PVC floor coating compositions, metal coating compositions, plastic coating composition, and adhesive compositions.

LED curing devices are used in dental work. An example of such a device is the ELIPAR™ FreeLight 2 LED curing light from 3M ESPE. This device emits light in the visible region with a peak irradiance at 460 nm. LED equipment is also being tested for use in the ink-jet printing, including, for example, by IST Metz.

Although LED lamps are available, photocurable compositions suitable for additive fabrication and curable by the use of LED light are not well known commercially. Laser curable resins are more common. For example, US Patent 7,211,368 reportedly discloses a liquid stereolithography resin comprising a first urethane acrylate oligomer, a first acrylate monomer, a polymerization modifier, a second urethane acrylate oligomer different from the first urethane acrylate oligomer, and a stabilizer. The first urethane acrylate oligomer is an aliphatic polyester urethane diacrylate oligomer, the first acrylate monomer is ethoxylated (3) trimethylolpropane acrylate, and the polymerization modifier is selected from the group consisting of isobornyl acrylate, ethoxylated (5) pentaerythritol tetraacrylate, an aliphatic urethane acrylate, tris-(2-hydroxyethyl)isocyanurate triacrylate, and mixtures thereof. The resin includes 5-35 weight % of an aliphatic polyester urethane diacrylate oligomer and 0.5-25 weight % ethoxylated (3) trimethylolpropane acrylate, wherein the resin includes 15-45 weight % ethoxylated (5) pentaerythritol tetraacrylate. However, the '368 patent indicates that a laser is used to cure the resin. Further, the '368 patent fails to disclose the use of an acid generating photoinitiator, such as a cationic photoinitiator.

More recently, some attention has been given to the use of LEDs in additive fabrication processes. U.S. Patent No. 6,927,018 and U.S. Patent Application Publication No. 2005/0227186 purportedly provide a method, article of manufacture and system for fabricating an article using photo-activatable building material. The method according to the '018 patent and the '186 publication includes the steps of applying a layer of the photo-activatable building material to a preselected surface, scanning the layer using a plurality of light-emitting centers to photo-activate the layer of photo-activatable building material in accordance with a predetermined photo-initiation process to obtain polymerization of the building material. Scanning is accomplished at a predetermined distance using a predetermined light intensity, and repeating the steps of applying the layer. Each layer is applied to an immediately previous layer, and the layer is scanned with the plurality of light-emitting centers to polymerize the building material until the article is fabricated. While the '018 patent and the '186 publication mention UV LEDs and laser diodes as suitable light-emitting centers, they fail to disclose detailed information on photo-activatable building material suitable for LED cure.

U.S. Patent No. 7,270,528 purportedly discloses a flash curing system for solid freeform fabrication which generates a plurality of radiation emitting pulses that forms a planar flash. The planar flash initiates curing of a curable material dispensed by a solid freeform fabrication apparatus. The '528 patent, while mentioning UV light-emitting diodes (LED) lamps in the specification, sets forth examples where a flash lamp is used to cure the resin composition. The resin composition illustrated in the '528 patent does contain a cationically curable monomer or a cationic photoinitiator.

U.S. Patent Application Publication No. 2008/0231731 or 2008/0169589 or European Patent Application No. EP 1950032 purportedly discloses a solid imaging apparatus that includes a replaceable cartridge containing a source of build material and an extendable and retractable flexible transport film for transporting the build material layer-by-layer from the cartridge to the surface of a build in an image plane. If desired, the apparatus can produce a fully reacted build. A high intensity UV source is said to cure the build between layers. The above publications state that the solid imaging radiation that is used to cure the build material can be "any actinic radiation which causes a photocurable liquid to react to produce a solid, whether a visible or UV source or other source,"

International Patent Publication No. WO 2008/118263 is directed to a system for building a three-dimensional object based on build data representing the three-dimensional object, wherein the system includes an extrusion head that deposits a radiation-curable material in consecutive layers at a high deposition rate. The radiation-curable material of each of the consecutive layers is cooled to a self-supporting state. The system is said to include a radiation source that selectively exposes portions of the consecutive layers to radiation at a high resolution in accordance with the build data. It is stated that the exposure head includes a linear array of high resolution, UV light-emitting diodes (LEDs). P71-1464 CUREBAR^{™} and P150-3072 PRINTHEAD^{™} are described as examples of suitable UV-radiation sources for the exposure head. The '263 publication fails to describe exemplary photocurable formulations suitable for curing by LED light in an additive fabrication process.

International Patent Publication No. WO 2005/103121, entitled "Method for photocuring of Resin Compositions", assigned to DSM IP Assets B.V., describes and claims Methods for Light Emitting Diode (LED) curing of a curable resin composition containing a photoinitiating system, characterized in that the highest wavelength at which absorption maximum of the photoinitiating system occurs (λ_{Max PIS}) is at least 20 nm below, and at most 100 nm below, the wavelength at which the emission maximum of the LED occurs (X_{LED}). The invention in this PCT patent application relates to the use of LED curing in structural applications, in particular in applications for the lining or relining of objects, and to objects containing a cured resin composition obtained by LED curing. This invention provides a simple, environmentally safe and readily controllable method for (re)lining pipes, tanks and vessels, especially for such pipes and equipment having a large diameter, in particular more than 15 cm. The specification does not describe LED radiation curable photocurable resins.

U.S. Patent Application Publication No. 2007/0205528 reportedly discloses an optical molding process wherein the radiation source used is a non-coherent source of radiation. The '528 publication indicates that the photocurable compositions are formulated so as to enable the production of three-dimensional articles having better performance when irradiated with conventional (non-coherent) UV rather than with Laser UV, and states that the photocurable compositions disclosed are more appropriate for UV non-coherent irradiation than for Laser UV. While the '528 publication mentions that "the exposure system uses irradiation from non-coherent light sources, e.g., a xenon fusion lamp, or light emitting diode bars," the exemplified exposure was reportedly carried out according to the method of WO 00/21735, which is said to describe an apparatus and a method wherein the photosensitive material is exposed to a light source illuminating a cross-section of a material by at least two modulator arrangements of individually controllable light modulators.

U.S. Patent Application Publication No. 2009/0267269A or WO 2009/132245 reportedly discloses a continuous-wave (CW) ultraviolet (UV) curing system for solid freeform fabrication (SFF), wherein the curing system is configured to provide an exposure of UV radiation for one or more layers of UV-curable material. It is reported that one or more UV exposures may initiate curing of a curable material in the layer dispensed by a solid freeform fabrication apparatus. According to the '269 or '245 publication, one approach to provide the single or multiple UV exposures is the use of one or more UV LEDs, which generate UV radiation without generating any substantial amounts of infrared (IR) radiation at the same time.

International Patent Publications WO 2007/118794 A1 , and WO 2009 /047151 A1 pertain to novel sulphonium salt photoinitiators and their use in photocurable compositions.

The foregoing shows that there is an unmet need to provide photocurable resin compositions for additive fabrication which are capable of curing by irradiation by LED light.

Regardless of which type of light source is used in an additive fabrication process, it is well known in the field of liquid radiation curable resins that hybrid liquid radiation curable resins produce cured three-dimensional articles with the most desirable combination of mechanical properties. A hybrid liquid radiation curable resin is a liquid radiation curable resin that comprises both free radical and cationic polymerizable components and photoinitiators. It is also well known that the cationically polymerizable components of a liquid radiation curable resin primarily contribute to the desirable combination of mechanical properties in a cured three-dimensional article, however, the cationically polymerizable components of a liquid radiation curable resin polymerize at a much slower rate than the free-radically polymerizable components. Consequently, the mechanical properties of the cured three-dimensional article develop over time after the initial cure of the hybrid liquid radiation curable resin. Liquid radiation curable resins for additive fabrication that contain cationically polymerizable components but no free-radical polymerizable components are known, however, such resins are generally considered to be too slow for use as rapid prototyping materials. Therefore, it is desired to increase the speed of the cationic cure in a liquid radiation curable resin for additive fabrication to enable the resin to attain the most desirable combination of physical properties as quickly as possible.

Since the cationic polymerizable components generally cure at a much slower rate than free-radical polymerizable components, it is highly desirable to speed the rate of cationic cure. Moreover, it is desirable to attain a resin with a fast photospeed that uses less photoinitiator so that the amounts of the components that positively contribute to the mechanical properties of a three-dimensional article formed from the liquid radiation curable resin can occupy a greater percentage of the liquid radiation curable resin. Furthermore, cationic photoinitiators that provide excellent photospeed at a variety of wavelengths commonly used in additive fabrication techniques are highly desirable.

Many cationic photoinitiators useful in additive fabrication also have poor thermal-stability. Thermal-stability is the ability of a liquid radiation curable resin to maintain its viscosity after exposure to temperature over time or during storage. Cationic photoinitiators are responsive to both light and temperature. At elevated temperatures, or at ambient temperature for a long time period, the cationic photoinitiators will be slowly activated and initiate a small amount of polymerization in the liquid radiation curable resin. Over time, this small amount of polymerization will create an undesirable increase in the viscosity of the liquid radiation curable resin for additive fabrication.

Hybrid liquid radiation curable resins that contain high amounts of inorganic filler, so-called filled compositions, are highly desirable because of the combination of strength and stiffness of the fully cured objects. Silica filler has been the most preferred inorganic filler for liquid radiation curable resins for additive fabrication for a number of years. Please see for example, US published applications 2006/0100301, assigned to DSM, and 2005/0040562, assigned to 3D Systems. Silica particles are predominately comprised of SiO₂. Examples of commercial embodiments of filled liquid radiation curable resins wherein silica nanoparticles are present are NanoTool™ and NanoForm™ 15100 Series by DSM Somos® and Accura® BlueStone™ by 3D Systems, Inc.

A high amount of inorganic filler is highly desirable in a liquid radiation curable resin due to its impact on the strength and stiffness of the three-dimensional object produced therefrom. However, highly filled compositions represent several challenges to the formulator of liquid radiation curable resins for additive fabrication. As the amount of filler increases, the viscosity of the liquid radiation curable resin also usually increases. A high viscosity liquid radiation curable resin is not desirable in some additive fabrication processes, for instance, stereolithography.

Furthermore, certain highly filled compositions are usually not as photo-stable as non-filled liquid radiation curable resins for additive fabrication. Photo-stability is the ability of a liquid radiation curable resin to maintain its viscosity after exposure to ambient light and undesirable light scattering in additive fabrication machines. Because liquid radiation curable resins for additive fabrication include one or more photoinitiators that are responsive to ambient light undesirable light scattering occurs in additive fabrication processes, partial polymerization occurs in the liquid radiation curable resin after it is exposed to light. This small amount of polymerization, over time, causes the viscosity of the liquid radiation curable resin to increase gradually. Achieving good photo-stability is particularly challenging in highly filled liquid radiation curable resins because of additional light scattering effects caused by the filler.

The most used cationic photoinitiators for current liquid radiation curable resins for additive fabrication are based upon sulfonium or iodonium cations in combination with either fluorophosphates or fluoroantimonate anions. Antimonate salts are often preferred because of their fast rate of cure. However, in some municipalities, objects fabricated from antimonate based compositions must be disposed of as a hazardous waste or hazardous constituent waste.

Furthermore, it is often desirable to have low antimony or antimony-free radiation curable compositions due to the adverse effect of antimonate salts on the desired applications of the three-dimensional article. For example, antimonate salts can have an undesirable effect in investment casting applications. Iodonium-borate photoinitiators are available, but suffer from the need to be sensitized at the wavelengths useful for stereolithography and have low thermal-stability. Sulfonium phosphate photoinitiators are available, but suffer from a poor rate of curing.

It would be desirable to have a cationic photoinitiator for additive fabrication that has fast photospeed, good photo-stability in filled compositions, good thermal-stability, and is antimony-free.

### Brief Summary of the Invention

The first aspect of the instant claimed invention is a liquid radiation curable resin for additive fabrication comprising an R-substituted aromatic thioether triaryl sulfonium tetrakis(pentafluorophenyl) borate cationic photoinitiator with a tetrakis(pentafluorophenyl)borate anion and a cation of the following formula (1): 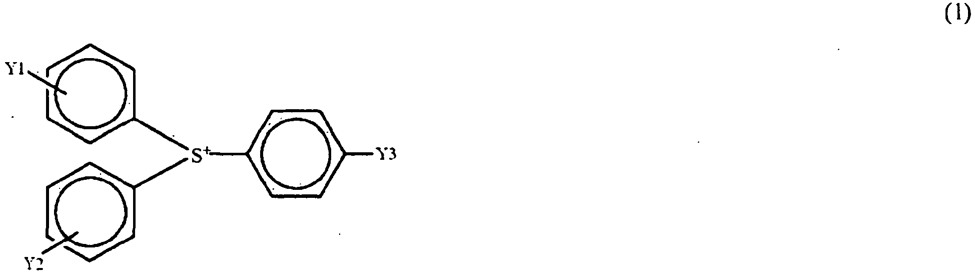 wherein Y1, Y2, and Y3 are the same or different and where Y1, Y2, or Y3 are R-substituted aromatic thioether with R being an acetyl group and silica nanoparticles comprising at least 80wt% silica preferably 90 wt% silica, more preferably 95 wt% silica.

The second aspect of the instant claimed invention is a process of forming a three-dimensional object comprising the steps of forming and selectively curing a layer of a liquid radiation curable resin for additive fabrication of the first aspect of the instant claimed invention and repeating the steps of forming and selectively curing a layer of a liquid radiation curable resin for additive fabrication of the first aspect of the instant claimed invention a plurality of times to obtain a three-dimensional object.

The third aspect of the instant claimed invention is a three-dimensional object formed from the liquid radiation curable resin for additive fabrication of the first aspect of the instant claimed invention.

### Detailed Description of the Invention

The first aspect of the instant claimed invention is a liquid radiation curable resin for additive fabrication comprising an R-substituted aromatic thioether triaryl sulfonium tetrakis(pentafluorophenyl) borate cationic photoinitiator with a tetrakis(pentafluorophenyl)borate anion and a cation of the following formula (1): 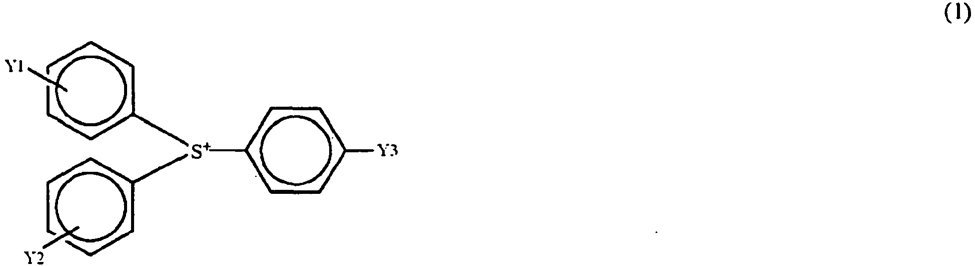 wherein Y1, Y2, and Y3 are the same or different and wherein Y 1, Y2, or Y3 are R-substituted aromatic thioether with R being an acetyl group.

*R-Substituted Aromatic Thioether Triaryl Sulfonium Tetrakis(pentafluorophenyl) Borate Cationic Photoinitiator*

In accordance with an embodiment, the liquid radiation curable resin for additive fabrication comprises an R-substituted aromatic thioether triaryl sulfonium tetrakis(pentafluorophenyl) borate cationic photoinitiator. The cationic photoinitiator generates photoacids upon irradiation of light. They generate Brönsted or Lewis acids upon irradiation.

Use of triaryl sulfonium salts in additive fabrication applications is known. Please see US Patent 6,368,769, to Asahi Denki Kogyo, which discusses triaryl sulfonium salts with tetraryl borate anions, including tetrakis(pentafluorophenyl) borate, and use of the compounds in stereolithography applications. Triarylsulfonium salts are disclosed in, for example, J Photopolymer Science & Tech (2000), 13(1), 117-118 and J Poly Science, Part A (2008), 46(11), 3820-29. Triarylsulfonium salts Ar₃S⁺MXₙ⁻ with complex metal halide anions such as BF₄⁻, AsF₆⁻, PF₆⁻, and SbF₆⁻, are disclosed in J Polymr Sci, Part A (1996), 34(16), 3231-3253.

The inventors have discovered that using an R-substituted aromatic thioether triaryl sulfonium tetrakis(pentafluorophenyl) borate cationic photoinitiator as the cationic photoinitiator in a liquid radiation curable resin for additive fabrication enables a liquid radiation curable resin that attains a fast photospeed, attains good thermal-stability, and attains good photo-stability.

In an embodiment, the R-substituted aromatic thioether triaryl sulfonium tetrakis(pentafluorophenyl) borate cationic photoinitiator has a tetrakis(pentafluorophenyl) borate anion and a cation of the following formula (1): 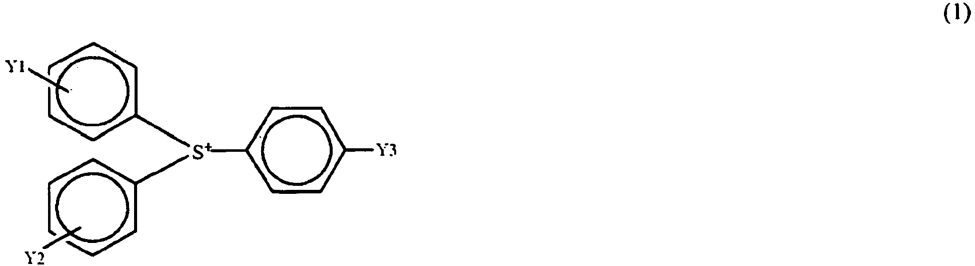 wherein Y1, Y2, and Y3 are the same or different and wherein Y1, Y2, or Y3 are R-substituted aromatic thioether with R being an acetyl group.

In an embodiment, Y1, Y2, and Y3 are the same. In another embodiment, Y1 and Y2 are the same, but Y3 is different. Y1, Y2, or Y3 are an R-substituted aromatic thioether with R being an acctyl group. Preferably Y1, Y2, or Y3 are a para-R-substituted aromatic thioether with R being an acetyl group.

A particularly preferred R-substituted aromatic thioether triaryl sulfonium tetrakis(pentafluorophenyl) borate cationic photoinitiator is tris(4-(4-acetylphenylthio)phenyl)sulfonium tetrakis(pentafluorophenyl)borate. Tris(4-(4-acetylphenylthio)phenyl)sulfonium tetrakis(pentafluorophenyl)borate is known commercially as IRGACURE® PAG-290 (formerly known by the development code GSID4480-1) and is available from Ciba/BASF.

The inventors have also discovered that an R-substituted aromatic thioether triaryl sulfonium tetrakis(pentafluorophenyl) borate cationic photoinitiator, for instance, tris(4-(4-acetylphenylthio)phenyl)sulfonium tetrakis(pentafluorophenyl)borate, is much more thermally-stable than other cationic photoinitiators. The improved thermal-stability allows liquid radiation curable resins for additive fabrication incorporating a triaryl sulfonium tetrakis(pentafluorophenyl) borate cationic photoinitiator instead of other conventional cationic photoinitiators to retain their viscosity at elevated temperatures for long periods of time..

Furthermore, the inventors have surprisingly found excellent performance in photo-stability of a liquid radiation curable resin for additive fabrication that comprises an R-substituted aromatic thioether triaryl sulfonium tetrakis(pentafluorophenyl) borate cationic photoinitiator, for instance tris(4-(4-acetylphenylthio)phenyl)sulfonium tetrakis(pentafluorophenyl)borate, in combination with high amounts of inorganic filler, such as silica-based filler. The interaction with light and inorganic filler, such as silica filler, creates added stability problems in highly filled liquid radiation curable resins for additive fabrication. However, use of R-substituted aromatic thioether triaryl sulfonium tetrakis(pentafluorophenyl) borate cationic photoinitiator in a liquid radiation curable resin enables the resin to attain comparable critical energy (Ec, E10) and depth of penetration (Dp) values to a resin incorporating a conventional cationic photoinitiator while achieving much better photo-stability.

In accordance with embodiments of the invention, the liquid radiation curable resin for additive fabrication includes a cationic polymerizable component in addition to an R-substituted aromatic thioether triaryl sulfonium tetrakis(pentafluorophenyl) borate cationic photoinitiator. In other embodiments, the liquid radiation curable resins for additive fabrication include cationic polymerizable components, free-radical photoinitiators, and free-radical polymerizable components. In some embodiments, the liquid radiation curable resins for additive fabrication include an R-substituted aromatic thioether triaryl sulfonium tetrakis(pentafluorophenyl) borate cationic photoinitiator and additional cationic photoinitiators and/or photosensitizers, along with a cationic polymerizable component and, optionally, free-radical polymerizable components and free-radical photoinitiators.

The liquid radiation curable resin for additive fabrication of the invention are curable by one or more LEDs operating at the appropriate wavelength. In an embodiment, the LEDs operate at a wavelength of from 200 nm - 460 nm, preferably from 300 nm - 400 nm, more preferably from 340 nm - 375 nm.

The R-substituted aromatic thioether triaryl sulfonium tetrakis(pentafluorophenyl) borate cationic photoinitiator can be present in any suitable amount. In embodiments, up to 20 wt%, more preferably up to 10 wt%, more preferably up to about 7 wt%. In embodiments, the R-substituted aromatic thioether triaryl sulfonium tetrakis(pentafluorophenyl) borate cationic photoinitiator is present in an amount from 0.1 wt% to 20 wt%, preferably from 0.1 wt% to 10 wt%, more preferably from 0.1 wt% to 7 wt%, more preferably from 0.2 wt% to 4 wt%. In some embodiments, the R-substituted aromatic thioether triaryl sulfonium tetrakis(pentafluorophenyl) borate cationic photoinitiator is present in an amount from 0.1 wt% to 2 wt%, preferably from 0.1 wt% to 1.5 wt%.

*Other Cationic Photoinitiators and Photosensitizers*

In accordance with an embodiment, the liquid radiation curable resin for additive fabrication includes a cationic photoinitiator in addition to an R-substituted aromatic thioether triaryl sulfonium tetrakis(pentafluorophenyl) borate cationic photoinitiator. Any suitable cationic photoinitiator can be used, for example, those selected from the group consisting of onium salts, halonium salts, iodosyl salts, selenium salts, sulfonium salts, sulfoxonium salts, diazonium salts, metallocene salts, isoquinolinium salts, phosphonium salts, arsonium salts, tropylium salts, dialkylphenacylsulfonium salts, thiopyrilium salts, diaryl iodonium salts, triaryl sulfonium salts, sulfonium antimonate salts, ferrocenes, di(cyclopentadienyliron)arene salt compounds, and pyridinium salts, and any combination thereof. Onium salts, e.g., iodonium salts, sulfonium salts and ferrocenes, have the advantage that they are thermally-stable. Thus, any residual photoinitiator does not continue to cure after the removal of the irradiating light. Cationic photoinitiators offer the advantage that they are not sensitive to oxygen present in the atmosphere.

Preferred mixtures of cationic photoinitiators include a mixture of: bis[4-diphenylsulfoniumphenyl]sulfide bishexafluoroantimonate; thiophenoxyphenylsulfonium hexafluoroantimonate (available as Chivacure 1176 from Chitec); tris(4-(4-acetylphenylthio)phenyl)sulfonium tetrakis(pentafluorophenyl)borate (Irgacure PAG-290 or GSID4480-1 from Ciba/BASF), iodonium, [4-(1-methylethyl)phenyl](4-methylphenyl)-, tetrakis(pentafluorophenyl)borate (available as Rhodorsil 2074 from Rhodia), 4-[4-(2-chlorobenzoyl)phenylthio]phenylbis(4-fluorophenyl)sulfonium hexafluoroantimonate (as SP-172) and SP-300 (both available from Adeka).

In some embodiments it is desirable for the liquid radiation curable resin for additive fabrication to include a photosensitizer. The term "photosensitizer" is used to refer to any substance that either increases the rate of photoinitiated polymerization or shifts the wavelength at which polymerization occurs; see textbook by G. Odian, Principles of Polymerization, 3rd Ed., 1991, page 222.Examples of photosensitizers include those selected from the group consisting of methanones, xanthenones, pyrenemethanols, anthracenes, pyrene, perylene, quinones, xanthones, thioxanthones, benzoyl esters, benzophenones, and any combination thereof. Particular examples of photosensitizers include those selected from the group consisting of [4-[(4-methylphenyl)thio]phenyl]phenyl-methanone, isopropyl-9H-thioxanthen-9-one, 1-pyrenemethanol, 9-(hydroxymethyl)anthracene, 9,10-diethoxyanthracene, 9,10-dimethoxyanthracene, 9,10-dipropoxyanthracene, 9,10-dibutyloxyanthracene, 9-anthracenemethanol acetate, 2-ethyl-9,10-dimethoxyanthracene, 2-methyl-9,10-dimethoxyanthracene, 2-t-butyl-9,10-dimethoxyanthracene, 2-ethyl-9,10-diethoxyanthracene and 2-methyl-9,10-diethoxyanthracene, anthracene, anthraquinones, 2-methylanthraquinone, 2-ethylanthraquinone, 2-tertbutylanthraquinone, 1-chloroanthraquinone, 2-amylanthraquinone, thioxanthones and xanthones, isopropyl thioxanthone, 2-chlorothioxanthone, 2,4-diethylthioxanthone, 1-chloro-4-propoxythioxanthone, methyl benzoyl formate, methyl-2-benzoyl benzoate, 4-benzoyl-4'-methyl diphenyl sulphide, 4,4'- bis(diethylamino) benzophenone, and any combination thereof.

Additionally, photosensitizers are useful in combination with photoinitiators in effecting cure with LED light sources emitting in the wavelength range of 300-475 nm. Examples of suitable photosensitizers include: anthraquinones, such as 2-methylanthraquinone, 2-ethylanthraquinone, 2-tertbutylanthraquinone, 1-chloroanthraquinone, and 2-amylanthraquinone, thioxanthones and xanthones, such as isopropyl thioxanthone, 2-chlorothioxanthone, 2,4-diethylthioxanthone, and 1-chloro-4-propoxythioxanthone, methyl benzoyl formate (Darocur MBF from Ciba), methyl-2-benzoyl benzoate (Chivacure OMB from Chitec), 4-benzoyl-4'-methyl diphenyl sulphide (Chivacure BMS from Chitec), 4,4'- bis(diethylamino) benzophenone (Chivacure EMK from Chitec).

In an embodiment, the photosensitizer is a fluorone, e.g., 5,7-diiodo-3-butoxy-6-fluorone, 5,7-diiodo-3-hydroxy-6-fluorone, 9-cyano-5,7-diiodo-3-hydroxy-6-fluorone, or a photosensitizer is 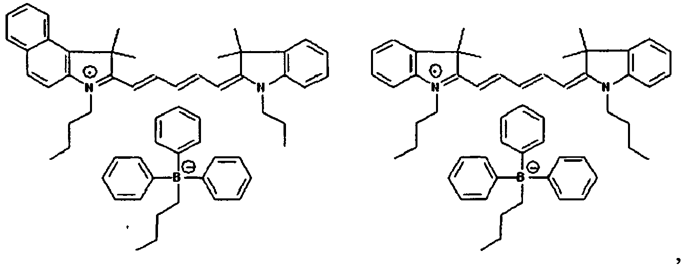 and any combination thereof.

The liquid radiation curable resin for additive fabrication can include any suitable amount of the photosensitizer, for example, in certain embodiments, in an amount up to about 10% by weight of the composition, in certain embodiments, up to about 5% by weight of the composition, and in further embodiments from about 0.05% to about 2% by weight of the composition.

When photosensitizers are employed, other photoinitiators absorbing at shorter wavelengths can be used. Examples of such photoinitiators include: benzophenones, such as benzophenone, 4-methyl benzophenone, 2,4,6-trimethyl benzophenone, and dimethoxybenzophenone, and 1-hydroxyphenyl ketones, such as 1-hydroxycyclohexyl phenyl ketone, phenyl (1-hydroxyisopropyl)ketone, 2-hydroxy-1-[4-(2-hydroxyethoxy) phenyl]-2-methyl-1-propanone, and 4-isopropylphenyl(1-hydroxyisopropyl)ketone, benzil dimethyl ketal, and oligo-[2-hydroxy-2-methyl-1-[4-(1-methylvinyl)phenyl] propanone] (Esacure KIP 150 from Lamberti). These photoinitiators when used in combination with a photosensitizer are suitable for use with LED light sources emitting at wavelengths from about 100 nm to about 300 nm.

A photosensitizer or co-initiator may be used to improve the activity of the cationic photoinitiator. It is for either increasing the rate of photoinitiated polymerization or shifting the wavelength at which polymerization occurs. The sensitizer used in combination with the above-mentioned cationic photoinitiator is not particularly limited. A variety of compounds can be used as photosensitizers, including heterocyclic and fused-ring aromatic hydrocarbons, organic dyes, and aromatic ketones. Examples of sensitizers include compounds disclosed by J. V. Crivello in Advances in Polymer Science, 62, 1 (1984), and by J. V. Crivello & K. Dietliker, "Photoinitiators for Cationic Polymerization" in Chemistry & technology of UV & EB formulation for coatings, inks & paints. Volume III, Photoinitiators for free radical and cationic polymerization. by K. Dietliker; [Ed. by P.K.T. Oldring], SITA Technology Ltd, London, 1991. Specific examples include polyaromatic hydrocarbons and their derivatives such as anthracene, pyrene, perylene and their derivatives, thioxanthones, α-hydroxyalkylphenones, 4-benzoyl-4'-methyldiphenyl sulfide, acridine orange, and benzoflavin.

The liquid radiation curable resin for additive fabrication can include any suitable amount of the other cationic photoinitiator or photosensitizer, for example, in certain embodiments, in an amount an amount from 0.1 to 10 wt% of the composition, in certain embodiments, from about 1 to about 8 wt% of the composition, and in further embodiments from about 2 to about 6 wt% of the composition. In an embodiment, the above ranges are particularly suitable for use with epoxy monomers.

In accordance with an embodiment, the liquid radiation curable resin for additive fabrication includes a photoinitiating system that is a photoinitiator having both cationic initiating function and free radical initiating function.

*Cationically Polymerizable Component*

In accordance with an embodiment, the liquid radiation curable resins for additive fabrication of the invention comprise at least one cationically polymerizable component, that is, a component which undergoes polymerization initiated by cations or in the presence of acid generators. The cationically polymerizable components may be monomers, oligomers, and/or polymers, and may contain aliphatic, aromatic, cycloaliphatic, arylaliphatic, heterocyclic moiety(ies), and any combination thereof. Suitable cyclic ether compounds can comprise cyclic ether groups as side groups or groups that form part of an alicyclic or heterocyclic ring system.

The cationic polymerizable component is selected from the group consisting of cyclic ether compounds, cyclic acetal compounds, cyclic thioethers compounds, spiro-orthoester compounds, cyclic lactone compounds, and vinyl ether compounds, and any combination thereof.

Examples of cationically polymerizable components include cyclic ether compounds such as epoxy compounds and oxetanes, cyclic lactone compounds, cyclic acetal compounds, cyclic thioether compounds, spiro orthoester compounds, and vinylether compounds. Specific examples of cationically polymerizable components include bisphenol A diglycidyl ether, bisphenol F diglycidyl ether, bisphenol S diglycidyl ether, brominated bisphenol A diglycidyl ether, brominated bisphenol F diglycidyl ether, brominated bisphenol S diglycidyl ether, epoxy novolac resins, hydrogenated bisphenol A diglycidyl ether, hydrogenated bisphenol F diglycidyl ether, hydrogenated bisphenol S diglycidyl ether, 3,4-epoxycyclohexylmethyl-3',4'-epoxycyclohexanecarboxylate, 2-(3,4-epoxycyclohexyl-5,5-spiro-3,4-epoxy)-cyclohexane-1,4-dioxane, bis(3,4-epoxycyclohexylmethyl)adipate, vinylcyclohexene oxide, 4-vinylepoxycyclohexane, vinylcyclohexene dioxide, limonene oxide, limonene dioxide, bis(3,4-epoxy-6-methylcyclohexylmethyl)adipate, 3,4-epoxy-6-methylcyclohexyl-3',4'-epoxy-6'-methylcyclohexanecarboxylate, ε-caprolactone-modified 3,4-epoxycyclohexylmethyl-3',4'-epoxycyclohexane carboxylates, trimethylcaprolactone-modified 3,4-epoxycyclohexylmethyl-3',4'-epoxycyclohexane carboxylates, β-methyl-δ-valerolactone-modified 3,4-epoxycyclohexcylmethyl-3',4'-epoxycyclohexane carboxylates, methylenebis(3,4-epoxycyclohexane), bicyclohexyl-3,3'-epoxide, bis(3,4-epoxycyclohexyl) with a linkage of-O-, -S-, -SO-, -SO₂-, -C(CH₃)₂-, -CBr₂-, - C(CBr₃)₂-, -C(CF₃)₂-, -C(CCl₃)₂-, or -CH(C₆H₅)-, dicyclopentadiene diepoxide, di(3,4-epoxycyclohexylmethyl) ether of ethylene glycol, ethylenebis(3,4-epoxycyclohexanecarboxylate), epoxyhexahydrodioctylphthalate, epoxyhexahydro-di-2-ethylhexyl phthalate, 1,4-butanediol diglycidyl ether, 1,6-hexanediol diglycidyl ether, neopentylglycol diglycidyl ether, glycerol triglycidyl ether, trimethylolpropane triglycidyl ether, polyethylene glycol diglycidyl ether, polypropylene glycol diglycidyl ether, polyglycidyl ethers of polyether polyol obtained by the addition of one or more alkylene oxides to aliphatic polyhydric alcohols such as ethylene glycol, propylene glycol, and glycerol, diglycidyl esters of aliphatic long-chain dibasic acids, monoglycidyl ethers of aliphatic higher alcohols, monoglycidyl ethers of phenol, cresol, butyl phenol, or polyether alcohols obtained by the addition of alkylene oxide to these compounds, glycidyl esters of higher fatty acids, epoxidated soybean oil, epoxybutylstearic acid, epoxyoctylstearic acid, epoxidated linseed oil, epoxidated polybutadiene, 1,4-bis[(3-ethyl-3-oxetanylmethoxy)methyl]benzene, 3-ethyl-3-hydroxymethyloxetane, 3-ethyl-3-(3-hydroxypropyl)oxymethyloxetane, 3-ethyl-3-(4-hydroxybutyl)oxymethyloxetane, 3-ethyl-3-(5-hydroxypentyl)oxymethyloxetane, 3-ethyl-3-phenoxymethyloxetane, bis((1-ethyl(3-oxetanyl))methyl)ether, 3-ethyl-3-((2-ethylhexyloxy)methyl)oxetane, 3-ethyl-((triethoxysilylpropoxymethyl)oxetane, 3-(meth)-allyloxymethyl-3-ethyloxetane, (3-ethyl-3-oxetanylmethoxy)methylbenzene, 4-fluoro-[1-(3-ethyl-3-oxetanylmethoxy)methyl]benzene, 4-methoxy-[1-(3-ethyl-3-oxetanylmethoxy)methyl]-benzene, [1-(3-ethyl-3-oxetanylmethoxy)ethyl]phenyl ether, isobutoxymethyl(3-ethyl-3-oxetanylmethyl)ether, 2-ethylhexyl(3-ethyl-3-oxetanylmethyl)ether, ethyldiethylene glycol(3-ethyl-3-oxetanylmethyl)ether, dicyclopentadiene (3-ethyl-3-oxetanylmethyl)ether, dicyclopentenyloxyethyl(3-ethyl-3-oxetanylmethyl)ether, dicyclopentenyl(3-ethyl-3-oxetanylmethyl)ether, tetrahydrofurfuyl(3-ethyl-3-oxetanylmethyl)ether, 2-hydroxyethyl(3-ethyl-3-oxetanylmethyl)ether, 2-hydroxypropyl(3-ethyl-3-oxetanylmethyl)ether, and any combination thereof. Examples of polyfunctional materials that are cationically polymerizable include dendritic polymers such as dendrimers, linear dendritic polymers, dendrigraft polymers, hyperbranched polymers, star branched polymers, and hypergraft polymers with epoxy or oxetane functional groups. The dendritic polymers may contain one type of polymerizable functional group or different types of polymerizable functional groups, for example, epoxy and oxetane functions.

In embodiments of the invention, the cationic polymerizable component is at least one selected from the group consisting of a cycloaliphatic epoxy and an oxetane. In a specific embodiment, the cationic polymerizable component is an oxetane, for example, an oxetane containing 2 or more than 2 oxetane groups. In another specific embodiment, the cationic polymerizable component is a cycloaliphatic epoxy, for example, a cycloaliphatic epoxy with 2 or more than 2 epoxy groups.

In an embodiment, the epoxide is 3,4-epoxycyclohexylmethyl-3',4-epoxycyclohexanecarboxylate (available as CELLOXIDE^{™} 2021P from Daicel Chemical, or as CYRACURE^{™} UVR-6105 from Dow Chemical), hydrogenated bisphenol A-epichlorohydrin based epoxy resin (available as EPONEX^{™} 1510 from Hexion), 1,4-cyclohexanedimethanol diglycidyl ether (available as HELOXY^{™} 107 from Hexion), a mixture of dicyclohexyl diepoxide and nanosilica (available as NANOPOX^{™}), and any combination thereof.

The above-mentioned cationically polymerizable compounds can be used singly or in combination of two or more thereof.

The liquid radiation curable resin for additive fabrication can include any suitable amount of the cationic polymerizable component, for example, in certain embodiments, in an amount an amount up to 80 wt% of the composition, in certain embodiments, from 10 to 80% by weight of the composition, and in further embodiments from 20 to 70 wt% of the composition.

In accordance with an embodiment, the polymerizable component of the liquid radiation curable resin for additive fabrication is polymerizable by both free-radical polymerization and cationic polymerization. An example of such a polymerizable component is a vinyloxy compound, for example, one selected from the group consisting of bis(4-vinyloxybutyl)isophthalate, tris(4-vinyloxybutyl) trimellitate, and combinations thereof. Other examples of such a polymerizable component include those containing an acrylate and an epoxy group, or an acrylate and an oxetane group, on a same molecule.

In embodiments, the liquid radiation curable resin for additive fabrication of the present invention includes a photoinitiating system. The photoinitiating system can be a free-radical photoinitiator or a cationic photoinitiator or a photoinitiator that contains both free-radical initiating function and cationic initiating function on the same molecule. The photoinitiator is a compound that chemically changes due to the action of light or the synergy between the action of light and the electronic excitation of a sensitizing dye to produce at least one of a radical, an acid, and a base.

*Radical Photoinitiator*

Typically, free radical photoinitiators are divided into those that form radicals by cleavage, known as "Norrish Type 1" and those that form radicals by hydrogen abstraction, known as "Norrish type II". The Norrish type II photoinitiators require a hydrogen donor, which serves as the free radical source. As the initiation is based on a bimolecular reaction, the Norrrish type II photoinitiators are generally slower than Norrish type I photoinitiators which are based on the unimolecular formation of radicals. On the other hand, Norrish type II photoinitiators possess better optical absorption properties in the near-UV spectroscopic region. Photolysis of aromatic ketones, such as benzophenone, thioxanthones, benzil, and quinones, in the presence of hydrogen donors, such as alcohols, amines, or thiols leads to the formation of a radical produced from the carbonyl compound (ketyl-type radical) and another radical derived from the hydrogen donor. The photopolymerization of vinyl monomers is usually initiated by the radicals produced from the hydrogen donor. The ketyl radicals are usually not reactive toward vinyl monomers because of the steric hindrance and the delocalization of an unpaired electron.

To successfully formulate a liquid radiation curable resin for additive fabrication, it is necessary to review the wavelength sensitivity of the photoinitiator(s) present in the composition to determine if they will be activated by the LED light chosen to provide the curing light.

In accordance with an embodiment, the liquid radiation curable resin for additive fabrication includes at least one free radical photoinitiator, e.g., those selected from the group consisting of benzoylphosphine oxides, aryl ketones, benzophenones, hydroxylated ketones, 1-hydroxyphenyl ketones, ketals, metallocenes, and any combination thereof.

In an embodiment, the liquid radiation curable resin for additive fabrication includes at least one free-radical photoinitiator selected from the group consisting of 2,4,6-trimethylbenzoyl diphenylphosphine oxide and 2,4,6-trimethylbenzoyl phenyl, ethoxy phosphine oxide, *bis(2,4,6-*trimethylbenzoyl)-phenylphosphineoxide, 2-methyl-1-[4-(methylthio)phenyl]-2-morpholinopropanone-1, 2-benzyl-2-(dimethylamino)-1-[4-(4-morpholinyl) phenyl]-1-butanone, 2-dimethylamino-2-(4-methyl-benzyl)-1-(4-morpholin-4-yl-phenyl)-butan-1-one, 4-benzoyl-4'-methyl diphenyl sulphide, 4,4'- bis(diethylamino) benzophenone, and 4,4'-bis(N,N'-dimethylamino) benzophenone (Michler's ketone), benzophenone, 4-methyl benzophenone, 2,4,6-trimethyl benzophenone, dimethoxybenzophenone, 1-hydroxycyclohexyl phenyl ketone, phenyl (1-hydroxyisopropyl)ketone, 2-hydroxy-1-[4-(2-hydroxyethoxy) phenyl]-2-methyl-1-propanone, 4-isopropylphenyl(1-hydroxyisopropyl)ketone, oligo-[2-hydroxy-2-methyl-1-[4-(1-methylvinyl)phenyl] propanone], camphorquinone, 4,4'-*bis*(diethylamino) benzophenone, benzil dimethyl ketal, *bis*(eta 5-2-4-cyclopentadien-1-yl) *bis*[2,6-difluoro-3-(1*H*-pyrrol-1-yl) phenyl] titanium, and any combination thereof.

For LED light sources emitting in the 300-475 nm wavelength range, especially those emitting at 365 nm, 390 nm, or 395 nm, examples of suitable free-radical photoinitiators absorbing in this area include: benzoylphosphine oxides, such as, for example, 2,4,6-trimethylbenzoyl diphenylphosphine oxide (Lucirin TPO from BASF) and 2,4,6-trimethylbenzoyl phenyl, ethoxy phosphine oxide (Lucirin TPO-L from BASF), *bis*(2,4,6-trimethylbenzoyl)-phenylphosphineoxide (Irgacure 819 or BAPO from Ciba), 2-methyl-1-[4-(methylthio)phenyl]-2-morpholinopropanone-1 (Irgacure 907 from Ciba), 2-benzyl-2-(dimethylamino)-1-[4-(4-morpholinyl) phenyl]-1-butanone (Irgacure 369 from Ciba), 2-dimethylamino-2-(4-methyl-benzyl)-1-(4-morpholin-4-yl-phenyl)-butan-1-one (Irgacure 379 from Ciba), 4-benzoyl-4'-methyl diphenyl sulphide (Chivacure BMS from Chitec), 4,4'- bis(diethylamino) benzophenone (Chivacure EMK from Chitec), and 4,4'-bis(N,N'-dimethylamino) benzophenone (Michler's ketone). Also suitable are mixtures thereof.

Additionally, photosensitizers are useful in conjunction with photoinitiators in effecting cure with LED light sources emitting in this wavelength range. Examples of suitable photosensitizers include: anthraquinones, such as 2-methylanthraquinone, 2-ethylanthraquinone, 2-tertbutylanthraquinone, 1-chloroanthraquinone, and 2-amylanthraquinone, thioxanthones and xanthones, such as isopropyl thioxanthone, 2-chlorothioxanthone, 2,4-diethylthioxanthone, and 1-chloro-4-propoxythioxanthone, methyl benzoyl formate (Darocur MBF from Ciba), methyl-2-benzoyl benzoate (Chivacure OMB from Chitec), 4-benzoyl-4'-methyl diphenyl sulphide (Chivacure BMS from Chitec), 4,4'- bis(diethylamino) benzophenone (Chivacure EMK from Chitec).

It is possible for LED UV light sources to be designed to emit light at shorter wavelengths. For LED light sources emitting at wavelengths from between about 100 and about 300 nm, it is desirable to employ a photosensitizer with a photoinitiator. When photosensitizers, such as those previously listed are present in the formulation, other photoinitiators absorbing at shorter wavelengths can be used. Examples of such photoinitiators include: benzophenones, such as benzophenone, 4-methyl benzophenone, 2,4,6-trimethyl benzophenone, and dimethoxybenzophenone, and , 1-hydroxyphenyl ketones, such as 1-hydroxycyclohexyl phenyl ketone, phenyl (1-hydroxyisopropyl)ketone, 2-hydroxy-1-[4-(2-hroxyethoxy) phenyl]-2-methyl-1-propanone, and 4-isopropylphenyl(1-hydroxyisopropyl)ketone, benzil dimethyl ketal, and oligo-[2-hydroxy-2-methyl-1-[4-(1-methylvinyl)phenyl] propanone] (Esacure KIP 150 from Lamberti).

LED light sources can also be designed to emit visible light. For LED light sources emitting light at wavelengths from about 475 nm to about 900nm, examples of suitable free radical photoinitiators include: camphorquinone, 4,4'- bis(diethylamino) benzophenone (Chivacure EMK from Chitec), 4,4'-bis(N,N'-dimethylamino) benzophenone (Michler's ketone), bis(2,4,6-trimethylbenzoyl)-phenylphosphineoxide (Irgacure 819 or BAPO from Ciba), metallocenes such as bis (eta 5-2-4-cyclopentadien-1-yl) bis [2,6-difluoro-3-(1H-pyrrol-1-yl) phenyl] titanium (Irgacure 784 from Ciba), and the visible light photoinitiators from Spectra Group Limited, Inc. such as H-Nu 470, H-Nu-535, H-Nu-635, H-Nu-Blue-640, and H-Nu-Blue-660.

In one embodiment of the instant claimed invention, the light emitted by the LED is UVA radiation, which is radiation with a wavelength between about 320 and about 400nm. In one embodiment of the instant claimed invention, the light emitted by the LED is UVB radiation, which is radiation with a wavelength between about 280 and about 320nm. In one embodiment of the instant claimed invention, the light emitted by the LED is UVC radiation, which is radiation with a wavelength between about 100 and about 280nm.

The liquid radiation curable resin for additive fabrication can include any suitable amount of the free-radical photoinitiator, for example, in certain embodiments, in an amount up to 10 wt% of the composition, in certain embodiments, from 0.1 to 10 wt% of the composition, and in further embodiments from 1 to 6 wt% of the composition.

*Radically Polymerizable Component*

In accordance with an embodiment of the invention, the liquid radiation curable resin for additive fabrication of the invention comprises at least one free-radical polymerizable component, that is, a component which undergoes polymerization initiated by free radicals. The free-radical polymerizable components are monomers, oligomers, and/or polymers; they are monofunctional or polyfunctional materials, i.e., have 1, 2, 3, 4, 5, 6, 7, 8, 9, 10, 20, 30, 40, 50, 100, or more functional groups that can polymerize by free radical initiation, may contain aliphatic, aromatic, cycloaliphatic, arylaliphatic, heterocyclic moiety(ies), or any combination thereof. Examples of polyfunctional materials include dendritic polymers such as dendrimers, linear dendritic polymers, dendrigraft polymers, hyperbranched polymers, star branched polymers, and hypergraft polymers; see US 2009/0093564 A1. The dendritic polymers may contain one type of polymerizable functional group or different types of polymerizable functional groups, for example, acrylates and methacrylate functions.

Examples of free-radical polymerizable components include acrylates and methacrylates such as isobornyl (meth)acrylate, bornyl (meth)acrylate, tricyclodecanyl (meth)acrylate, dicyclopentanyl (meth)acrylate, dicyclopentenyl (meth)acrylate, cyclohexyl (meth)acrylate, benzyl (meth)acrylate, 4-butylcyclohexyl (meth)acrylate, acryloyl morpholine, (meth)acrylic acid, 2-hydroxyethyl (meth)acrylate, 2-hydroxypropyl (meth)acrylate, 2-hydroxybutyl (meth)acrylate, methyl (meth)acrylate, ethyl (meth)acrylate, propyl (meth)acrylate, isopropyl (meth)acrylate, butyl (meth)acrylate, amyl (meth)acrylate, isobutyl (meth)acrylate, t-butyl (meth)acrylate, pentyl (meth)acrylate, caprolactone acrylate, isoamyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, decyl (meth)acrylate, isodecyl (meth)acrylate, tridecyl (meth)acrylate, undecyl (meth)acrylate, lauryl (meth)acrylate, stearyl (meth)acrylate, isostearyl (meth)acrylate, tetrahydrofurfuryl (meth)acrylate, butoxyethyl (meth)acrylate, ethoxydiethylene glycol (meth)acrylate, benzyl (meth)acrylate, phenoxyethyl (meth)acrylate, polyethylene glycol mono(meth)acrylate, polypropylene glycol mono(meth)acrylate, methoxyethylene glycol (meth)acrylate, ethoxyethyl (meth)acrylate, methoxypolyethylene glycol (meth)acrylate, methoxypolypropylene glycol (meth)acrylate, diacetone (meth)acrylamide, beta-carboxyethyl (meth)acrylate, phthalic acid (meth)acrylate, dimethylaminoethyl (meth)acrylate, diethylaminoethyl (meth)acrylate, butylcarbamylethyl (meth)acrylate, n-isopropyl (meth)acrylamide fluorinated (meth)acrylate, 7-amino-3,7-dimethyloctyl (meth)acrylate.

Examples of polyfunctional free-radical polymerizable components include those with (meth)acryloyl groups such as trimethylolpropane tri(meth)acrylate, pentaerythritol (meth)acrylate, ethylene glycol di(meth)acrylate, bisphenol A diglycidyl ether di(meth)acrylate, dicyclopentadiene dimethanol di(meth)acrylate, [2-[1,1-dimethyl-2-[(1-oxoallyl)oxy]ethyl]-5-ethyl-1,3-dioxan-5-yl]methyl acrylate; 3,9-bis(1, 1-dimethyl-2-hydroxyethyl)-2,4,8, 10-tetraoxaspiro[5.5]undecane di(meth)acrylate; dipentaerythritol monohydroxypenta(meth)acrylate, propoxylated trimethylolpropane tri(meth)acrylate, propoxylated neopentyl glycol di(meth)acrylate, tetraethylene glycol di(meth)acrylate, polyethylene glycol di(meth)acrylate, 1,4-butanediol di(meth)acrylate, 1,6-hexanediol di(meth)acrylate, neopentyl glycol di(meth)acrylate, polybutanediol di(meth)acrylate, tripropyleneglycol di(meth)acrylate, glycerol tri(meth)acrylate, phosphoric acid mono- and di(meth)acrylates, C₇-C₂₀ alkyl di(meth)acrylates, tris(2-hydroxyethyl)isocyanurate tri(meth)acrylate, tris(2-hydroxyethyl)isocyanurate di(meth)acrylate, pentaerythritol tri(meth)acrylate, pentaerythritol tetra(meth)acrylate, dipentaerythritol hexa(meth)crylate, tricyclodecane diyl dimethyl di(meth)acrylate and alkoxylated versions (e.g., ethoxylated and/or propoxylated) of any of the preceding monomers, and also di(meth)acrylate of a diol which is an ethylene oxide or propylene oxide adduct to bisphenol A, di(meth)acrylate of a diol which is an ethylene oxide or propylene oxide adduct to hydrogenated bisphenol A, epoxy (meth)acrylate which is a (meth)acrylate adduct to bisphenol A of diglycidyl ether, diacrylate of polyoxyalkylated bisphenol A, and triethylene glycol divinyl ether, and adducts of hydroxyethyl acrylate.

In accordance with an embodiment, the polyfunctional (meth)acrylates of the polyfunctional component may include all methacryloyl groups, all acryloyl groups, or any combination of methacryloyl and acryloyl groups. In an embodiment, the free-radical polymerizable component is selected from the group consisting of bisphenol A diglycidyl ether di(meth)acrylate, ethoxylated or propoxylated bisphenol A or bisphenol F di(meth)acrylate, dicyclopentadiene dimethanol di(meth)acrylate, [2-[1,1-dimethyl-2-[(1-oxoallyl)oxy]ethyl]-5-ethyl-1,3-dioxan-5-yl]methyl acrylate, dipentaerythritol monohydroxypenta(meth)acrylate, dipentaerythritol hexa(meth)crylate, propoxylated trimethylolpropane tri(meth)acrylate, and propoxylated neopentyl glycol di(meth)acrylate, and any combination thereof.

In another embodiment, the free-radical polymerizable component is selected from the group consisting of bisphenol A diglycidyl ether diacrylate, dicyclopentadiene dimethanol diacrylate, [2-[1,1-dimethyl-2-[(1-oxoallyl)oxy]ethyl]-5-ethyl-1,3-dioxan-5-yl]methyl acrylate, dipentaerythritol monohydroxypentaacrylate, propoxylated trimethylolpropane triacrylate, and propoxylated neopentyl glycol diacrylate, and any combination thereof.

In specific embodiments, the liquid radiation curable resins for additive fabrication of the invention include one or more of bisphenol A diglycidyl ether di(meth)acrylate, dicyclopentadiene dimethanol di(meth)acrylate, dipentaerythritol monohydroxypenta(meth)acrylate, propoxylated trimethylolpropane tri(meth)acrylate, and/or propoxylated neopentyl glycol di(meth)acrylate, and more specifically one or more of bisphenol A diglycidyl ether diacrylate, dicyclopentadiene dimethanol diacrylate, dipentaerythritol monohydroxypentaacrylate, propoxylated trimethylolpropane triacrylate, and/or propoxylated neopentyl glycol diacrylate.

The liquid radiation curable resin for additive fabrication can include any suitable amount of the free-radical polymerizable component, for example, in certain embodiments, in an amount up to 40 wt% of the composition, in certain embodiments, from 2 to 40 wt% of the composition, in other embodiments from 10 to 40 wt%, and in further embodiments from 10 to 25 wt% of the composition.

*Stabilizers*

In embodiments of the invention, the liquid radiation curable resins for additive fabrication include a stabilizer. Stabilizers are often added to the compositions in order to prevent a viscosity build-up, for instance a viscosity build-up during usage in a solid imaging process. Useful stabilizers include those described in U.S. Pat. No. 5,665,792, the entire disclosure of which is hereby incorporated by reference. Such stabilizers are usually hydrocarbon carboxylic acid salts of group IA and IIA metals. Most preferred examples of these salts are sodium bicarbonate, potassium bicarbonate, and rubidium carbonate. Solid stabilizers are generally not preferred in filled compositions. A 15-23% sodium carbonate solution is preferred for formulations of this invention with recommended amounts varying between 0.05 to 3.0% by weight of composition, more preferably from 0.05 to 1.0 wt%, more preferably from 0.1 to 0.5% by weight of composition. Alternative stabilizers include polyvinylpyrrolidones and polyacrylonitriles.

*Other Components*

Other possible additives include dyes, pigments, talc, glass powder, alumina, alumina hydrate, magnesium oxide, magnesium hydroxide, barium sulfate, calcium sulfate, calcium carbonate, magnesium carbonate, silicate mineral, diatomaceous earth, silica sand, silica powder, titanium oxide, aluminum powder, bronze powder, zinc powder, copper powder, lead powder, gold powder, silver dust, glass fiber, titanic acid potassium whisker, carbon whisker, sapphire whisker, beryllia whisker, boron carbide whisker, silicon carbide whisker, silicon nitride whisker, glass beads, hollow glass beads, metaloxides and potassium titanate whisker), antioxidants, wetting agents, photosensitizers for the free-radical photoinitiator, chain transfer agents, leveling agents, defoamers, surfactants and the like.

In accordance with an embodiment, the liquid radiation curable resin for additive fabrication can further include a chain transfer agent, particularly a chain transfer agent for a cationic monomer. The chain transfer agent has a functional group containing active hydrogen. Examples of the active hydrogen-containing functional group include an amino group, an amide group, a hydroxyl group, a sulfo group, and a thiol group. In an embodiment, the chain transfer agent terminates the propagation of one type of polymerization, i.e., either cationic polymerization or free-radical polymerization and initiates a different type of polymerization, i.e., either free-radical polymerization or cationic polymerization. In accordance with an embodiment, chain transfer to a different monomer is a preferred mechanism. In embodiments, chain transfer tends to produce branched molecules or crosslinked molecules. Thus, chain transfer offers a way of controlling the molecular weight distribution, crosslink density, thermal properties, and/or mechanical properties of the cured resin composition.

Any suitable chain transfer agent can be employed. For example, the chain transfer agent for a cationic polymerizable component is a hydroxyl-containing compound, such as a compound containing 2 or more than 2 hydroxyl-groups. In an embodiment, the chain transfer agent is selected from the group consisting of a polyether polyol, polyester polyol, polycarbonate polyol, ethoxylated or propoxylated aliphatic or aromatic compounds having hydroxyl groups, dendritic polyols, hyperbranched polyols. An example of a polyether polyol is a polyether polyol comprising an alkoxy ether group of the formula [(CH₂)ₙO]ₘ, wherein n can be 1 to 6 and m can be 1 to 100.

A particular example of a chain transfer agent is polytetrahydrofuran such as TERATHANE^{™}.

The liquid radiation curable resin for additive fabrication can include any suitable amount of the chain transfer agent, for example, in certain embodiments, in an amount up to about 50% by weight of the composition, in certain embodiments, up to about 30% by weight of the composition, and in certain other embodiments from about 10% to about 20% by weight of the composition.

The liquid radiation curable resin for additive fabrication of the invention can further include one or more additives selected from the group consisting of bubble breakers, antioxidants, surfactants, acid scavengers, pigments, dyes, thickneners, flame retardants, silane coupling agents, ultraviolet absorbers, resin particles, core-shell particle impact modifiers, soluble polymers and block polymers, organic fillers, inorganic fillers, or organic-inorganic hybrid fillers of sizes ranging from about 8 nanometers to about 50 microns.

*Inorganic Filler*

An inorganic filler is present in the liquid radiation curable resin composition an amount from 5 wt% to 90 wt%, preferably from 10 wt% to 75 wt%, more preferably from 30 to 75 wt%. The inorganic filler comprises silica (SiO₂) nanoparticles comprising 80 wt%, more preferably 90 wt%, more preferably 95 wt% of silica. Preferred silica nanoparticles are Nanopox products from Nanoresins, such as Nanopox A610. Examples of silica microparticles are NP-30 and NP-100 from AGC Chemicals, SUNSPACER™ 04.X and 0.4X ST-3 from Suncolor Corporation. Examples of such silica nanoparticles are SUNSPHERES™ 200nm such as 0.2 and 0.2-STP-10. Please see US Patent 6013714 for further examples of silica particles. However, depending on the size and other properties of the silica nanoparticles, the thermal-stability of the liquid radiation curable resin may decrease when certain silica nanoparticles are added to the liquid radiation curable resin due to the acidity of the silica.

As mentioned above, the inventors have found a surprising combination of a triaryl sulfonium tetrakis(pentafluorophenyl)borate cationic photoinitiator, preferably, tris(4-(4-acetylphenylthio)phenyl)sulfonium tetrakis(pentafluorophenyl)borate, and high amounts of silica nanoparticles which comprise greater than 80 wt%, more preferably 90 wt%, more preferably 95 wt% of silica. The combination yields liquid radiation curable resins for additive fabrication that attain excellent photo-stability and thermal-stability.

Nanoparticles are defined herein as particles having an average particle diameter in the range from 1 nm to 999 nm as measured using laser diffraction particle size analysis in accordance with ISO13320:2009. A suitable device for measuring the average particle diameter of nanoparticles is the LB-550 machine, available from Horiba Instruments, Inc, which measures particle diameter by dynamic light scattering. Microparticles are defined herein as particles that have an average particle diameter in the range from 1 to about 100 microns as measured in accordance with ISO13320:2009.

The second aspect of the instant claimed invention is a process of forming a three-dimensional object comprising the steps of forming and selectively curing a layer of a liquid radiation curable resin for additive fabrication comprising a triaryl sulfonium tetrakis(pentafluorophenyl)borate photoinitiator and repeating the steps of forming and selectively curing a layer of a liquid radiation curable resin for additive fabrication comprising a triaryl sulfonium tetrakis(pentafluorophenyl)borate photoinitiator a plurality of times to obtain a three-dimensional object. The process can be performed using any suitable means of imaging radiation, such as an LED, a lamp, or a laser. Moreover, the process can be performed on a liquid radiation curable resin contained in a vat or coated on a substrate. Preferably, the process is performed by one or more LEDs. The LEDs preferably operate from 200 nm - 460 nm, preferably from 300 nm - 400 nm, more preferably from 340 nm - 370 nm.

The third aspect of the instant claimed invention is a three-dimensional object formed from the liquid radiation curable resin for additive fabrication of the present application.

The following examples further illustrate the invention as defined by the appended claims but, of course, should not be construed as in any way limiting its scope.

### Examples

These examples illustrate embodiments of the liquid radiation curable resins for additive fabrication of the instant invention. Table 1 describes the various components of the liquid radiation curable resins for additive fabrication used in the present examples.

**TABLE 1**

| Component | Function in Formula | Chemical Descriptor | Supplier |
|---|---|---|---|
| BYK A 501 | Bubble breaker | Naphtha/methoxy propanol acetate | BYK-Chemie |
| NK Ester A-DOG | Free radical polymerizable compound | [2-[1,1-dimethyl-2-[(1-oxoallyl)oxy]ethyl]-5-ethyl-1,3-dioxan-5-yl]methyl acrylate | Kowa |
| CD 406 | Free radical polymerizable compound | 1,4-Cyclohexanedimethanol diacrylate | Sartomer |
| Chivacure 1176 | Cationic Photoinitiator | A mixture of: bis[4-diphenylsulfoniumphenyl]sulfide bishexafluoroantimonate; thiophenoxyphenylsulfonium hexafluoroantimonate and propylene carbonate. | Chitec |
| Chivacure BMS | Photosensitizing agent | [4-[(4-methylphenyl)thio]phenyl]phenyl-methanone | Chitec |
| DG-0071 | Stabilizer | 22% of sodium carbonate solution | Desotech |
| DPHA | Radical Polymerizable Compound | Dioentaerythritol hexaacrylate | Sigma Aldrich |
| EPONOX 1510 | Cationic Polymerizable Compound | Hydrogenated bisphenol A-epichlorohydrin based epoxy resin | Hexion |
| Heloxy 68 | Cationic Polymerizable Compound | Neopentylglycol diglycidylether | Hexion |
| HQMME | Antioxidant | Hydroquinone monomethyl ether | |
| Intermediate DG-0049 | Pigment dispersion | Pigment dispersion for color effects | Desotech |
| Irgacure 184 | Radical Photoinitiator | 1-Hydroxy-1-cyclohexyl phenyl ketone | BASF |
| Irgacure PAG-290 | Cationic Photoinitiator | tris(4-(4-acetylphenylthio)phenyl)sulfonium tetrakis(pentafluorophenyl)borate | BASF |
| Longnox 10 | Antioxidant | Pentaerythritol tetrakis[(3,5-di-tert-butyl-4-hydroxyphenyl)propionate] | Longchem C&S Int. |
| Nanopox A610 | Filler in reactive monomer | 40% 15nm of SiO₂ Particle in epoxy monomer | Nanoresins |
| OXT-101 | Cationic Polymerizable Compound | 3-Ethyl-3-oxetanemethanol | Toagosei |
| Polyvinyl pyrrolidone | Acid scavenger | Poly[N-vinylpyrrolidinone]; PVP | Sigma Aldrich |
| Rhodorsil 2074 | Photoacid generator | Iodonium, [4-(1-methylethyl)phenyl](4-methylphenyl)-, tetrakis(pentafluorophenyl)borate | Rhodia |
| Rubidium carbonate | Acid scavenger | Dirubidium carbonate; Rb₂CO₃ | Sigma Aldrich |
| Silwet L 7600 | Leveling agent | Polyalkyleneoxide modified polydimethylsiloxane | Momentive |
| SR-399LV, J | Radical Polymerizable Compound | Dipentaerythritol monohydroxypentaacrylate | Sartomer |
| SR-833S | Radical Polymerizable Compound | Tricyclodecane Dimethanol Diacrylate | Sartomer |
| Sunspacer 4.0X-ST-3 | Filler | SiO₂ Particle (4 micron average particle size) | Suncolor |
| TERATHANE 1000 | Chain transfer agent for cationic monomers | Poly(tetramethylene ether) glycol | Invista |

*Examples 1 - 7* - Reference examples not to be construed as an example of the invention

Various liquid radiation curable resins for additive fabrication were prepared using an R-substituted aromatic thioether triaryl sulfonium tetrakis(pentafluorophenyl) borate cationic photoinitiator. A similar composition was prepared using an alternative antimony-free cationic photoinitiator. These samples were tested according to the methods for working curve measurement and dynamic mechanical analysis detailed below. Working curve data was obtained using a single UV LED "bare bulb" (Model No. NCSU033A; Nichia Corporation, Japan) having a peak wavelength of 365 nm in a light curing apparatus, wherein the single LED light is bottom-mounted on a flat surface inside a 30 °C chamber and positioned in an upward-looking arrangement and pointing vertically according to the below method. Real-time dynamic mechanical analysis was performed using a mercury lamp with a 365 nm interference filter, respectively. The results are presented in Table 2 and Table 3.

*Working Curve Measurement*

The photo cure speed test using 365 nm LED light is used to measure values for Ec and Dp of the example and comparative example compositions in Table 2 and Table 3. A single UV LED "bare bulb" (Model No. NCSU033A; Nichia Corporation, Japan) having a peak wavelength of 365 nm is used as the LED light source in a light curing apparatus, wherein the single LED light is bottom-mounted on a flat surface inside a 30 °C chamber and positioned in an upward-looking arrangement and pointing vertically. The LED light is powered by a 3.30 V / 0.050 A DC output from a Programmable Power Supply (Model No. PSS-3203; GW Instek).

A 10-mil sheet of polyester film (Melinex # 515, Polybase Mylar D, 0.010 gauge) is placed at a distance of 12 mm above from the bottom of the LED light bulb. A drop of the liquid resin is placed on the polyester film over the center of the LED light. The resin is exposed to the LED light through the polyester film for a specific time interval. The process is repeated with fresh resin for 2, 4, 6, 8, 10 second exposure times or up to 12, 16, or 20 seconds for slow curing resin formulations.

After exposure to the LED light, the sample is allowed to age inside the 30 °C chamber for at least 15 minutes, after which time any uncured resin is removed from the exposed areas by blotting with a Kimwipe EX-L (Kimberly Clark). A thickness measurement is then taken on the center of the exposed area using an ABSOLUTE Digimatic Indicator (Model ID- C 112CE, Mitutoyo Corporation, Japan). The measured thickness of each sample is plotted as a function of the natural logarithm of the exposure time. The depth of penetration (Dp; mil) of the resin composition is the slope of the least squares fit line. The Ec (sec) is the X-axis crossing point (Y=0) of the line. The E₃, E₄, or E₅ is, respectively, the time (in seconds) required to produce a layer having a thickness of 3, 4, or 5 mils, respectively.

Alternatively, when the intensity of the incident light (mW/cm²) from the light source on the resin surface is known, the exposure energy (mJ/cm²) rather than the exposure time (in seconds) is used for calculating the Dp and Ec values.

*Measurement of Storage Shear Modulus (G) by Real Time Dynamic Mechanical Analysis (RT-DMA)*

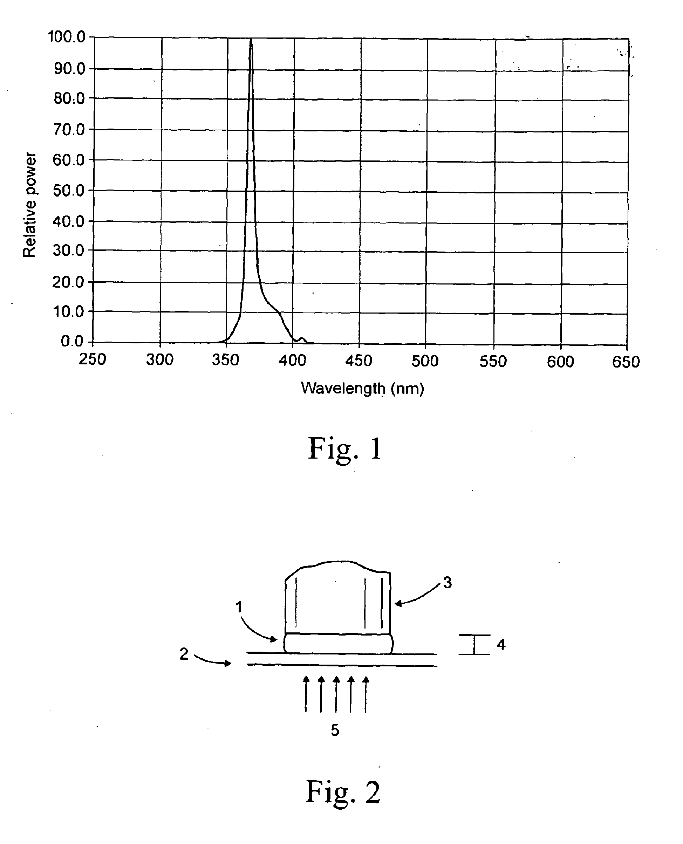

Real Time Dynamic Mechanical Analysis (RT-DMA), including the storage shear modulus (G'), is carried out under ambient lab conditions (20-23 °C and 25-35% RH), on compositions undergoing curing using a StressTech Rheometer (Reologicia Instruments AB, Sweden) with an 8 mm plate, a gap of 0.1 mm, and modified to include a mercury lamp light source (OMNICURE Series 2000 available from EXFO), fitted with a 365 nm interference filter (also available from EXFO) placed in the light path and a liquid-filled light guide for conveying light from the source to the rheometer. The 365 nm interference filter produces the spectral output shown in Figure 1. The samples are evaluated under the following parameters: 10 s of equilibrium time; frequency of 10 Hz; 50 mW/cm2 light intensity by the IL 1400 radiometer with XRL140B detector (International Light, Newburyport, MA); 1.0 s exposure that starts at 2.1 seconds from the beginning of data collection; FFT smoothing of curves; G' taken at 2.5, 2.7, 3, 4, and 6 s from the beginning of data collection by using the accompanying software for data analysis.

Figure 2 shows a schematic of the RT-DMA apparatus. The liquid radiation curable resin (1) is placed on a plane (2). The amount of liquid resin used should be approximately the amount indicated in the figure. The plane is a quartz plate that is sold with the StressTech Rheometer. The 8 mm plate (3) is positioned with a 0.1 mm gap (4) between the plate and the plane. The gap is set via the software accompanying the StressTech Rheometer. Light (5) is provided though the plane (2). Please see the publication "Dynamic Mechanical Analysis of UV-Curable Coatings While Curing" by Robert W. Johnson available at http://reologicainstruments.com/PDF%20files/BobJohnsonUVpaper.pdf for more information on RT-DMA.

**TABLE 2**

| | **Ex1** | **Ex2** | **Ex3** |
|---|---|---|---|
| EBECRYL-3700 | 25 | 17.237 | 24.449 |
| CD 406 | 7 | | 6.846 |
| Celloxide 2021 P | 36 | 52.959 | 34.326 |
| OXT-101 | | 8.431 | |
| TERATHANE-1000 | 25 | 10.254 | 24.449 |
| Chivacure 1176 | | 3.998 | 3.325 |
| Irgacure PAG-290 | 4 | 2 | 2.2 |
| Irgacure 184 | 3 | 4.9 | 4.401 |
| PVP | | 0.005 | |
| Rubidium carbonate | | | 0.005 |
| Silwet L 7600 | | 0.196 | |
| BYK A 501 | | 0.02 | |
| Total | 100 | 100 | 100 |
| | | | |
| Dp (mil) | 3.53 | 5.69 | 5.42 |
| Ec (s) | 1.13 | 1.15 | 1.22 |
| E3 (s) | 2.64 | 1.96 | 2.13 |
| E4 (s) | 3.5 | 2.33 | 2.56 |
| E5 (s) | 4.65 | 2.78 | 3.08 |
| G' 0.4 sec after light on (Pa) | 1270 | 1150 | 3060 |
| G' 0.6 sec after light on (Pa) | 5510 | 10700 | 76900 |
| G' 0.9 sec after light on (Pa) | 119000 | 99300 | 456000 |
| G' 1.9 sec after light on (Pa) | 627000 | 277000 | 1580000 |
| G' 3.9 sec after light on (Pa) | 1030000 | 459000 | 2540000 |

**TABLE 3**

| | **Ex4** | **Ex5** | **Ex6** | **Ex7** | **Comp1** |
|---|---|---|---|---|---|
| Irgacure PAG 290 | 0.98 | 1.00 | 1.00 | 1.50 | |
| Rhodorsil PI-2074 | | | | | 2.00 |
| Chivacure BMS | | | | | 1.00 |
| Irgacure 184 | 6.00 | 6.00 | 6.00 | 6.00 | 6.00 |
| SR399J | | | 6.24 | 5.74 | 4.94 |
| DPHA | 7.02 | 4.00 | | | |
| NK Ester A-DOG | 20.00 | 20.00 | 15.57 | 15.57 | 15.57 |
| Celloxide 2021 P | 45.84 | 45.84 | | | |
| Terathane 1000 | 10.19 | 13.19 | | | |
| OXT-101 | 9.17 | 9.17 | 15.70 | 15.70 | 15.70 |
| Longnox 10 | 0.50 | 0.50 | 1.00 | 1.00 | 0.50 |
| PVP | 0.01 | 0.01 | | | |
| DG-0049 | 0.30 | 0.30 | 0.20 | 0.20 | |
| Epon 1510 | | | 54.30 | 54.30 | 54.30 |
| Total | 100 | 100 | 100 | 100 | 100 |
| | | | | | |
| G' 0.5 sec after light on (Pa) | 18810 | 9884 | 809 | 2140 | 449 |
| G' 0.7 sec after light on (Pa) | 195100 | 123000 | 44920 | 33620 | 21440 |
| G' 1.0 sec after light on (Pa) | 742500 | 555100 | 360000 | 270900 | 219400 |
| G' 2.0 sec after light on (Pa) | 1726000 | 1400000 | 1099000 | 866900 | 697800 |
| G' 4.0 sec after light on (Pa) | 2305000 | 1968000 | 1565000 | 1261000 | 1014000 |

*Examples 8-11*

Various liquid radiation curable resins were prepared according to methods well known in the art. The amount and type of the cationic photoinitiator was varied from Chivacure 1176 (Comparative Examples 8, 9, 10) to Irgacure PAG-290 (Examples 8, 9, 10, 11). Since Chivacure 1176 is a 50/50 mixture of cationic photoinitiator and propylene carbonate, an amount of propylene carbonate was added to some of the formulations containing PAG-290 in order to keep the amount of cationic photoinitiator plus propylene carbonate constant. Working curve data was prepared using a solid state laser operating at a wavelength of 354.7 nm in accordance with the below method. Photo-stability data (hrs until gel time), and thermal-stability data (initial viscosity, 15 day viscosity, and 24 days viscosity) were measured in accordance with the below methods. The details of the compositions of each example (Ex) and comparative example (Comp) are specified in Table 4 with each component represented as weight percent of the total composition.

*Working Curve measurement*

The working curve is a measure of the photospeed of the particular material. It represents the relationship between the thickness of a layer of liquid radiation curable resin produced as a function of the exposure given. For all formulations, the exposure-working curve of the formula is determined using methods well known in the art.

The exposure response for each formulation is measured using a 20 g sample of the formulation in a 100 mm diameter petri dish held at 30 °C and 30% RH. The surface of the formulation is exposed with the indicated light source. The exposures are made in half-inch squares (exposure regions) which are scanned out by drawing consecutive parallel lines approximately 25.4 microns apart on the surface of the liquid in the petri dish at 72 mW. Different exposure regions are exposed to different levels of known incident energy to obtain different cured thicknesses. The spot diameter at the liquid surface is approximately 0.0277 cm in diameter. After waiting at least 15 minutes for the exposed panels to harden, the panels are removed from the petri dish and excess, uncured resin is removed by blotting with a Kimwipe EX-L (Kimberly Clark). Film thickness is measured with a Mitutoyo Model ID-C1 12CE Indicator Micrometer. Film thickness is a linear function of the natural logarithm of the exposure energy; the slope of the regression is Dp (units of micron or mil) and Ec is the x-axis intercept of the regression fit (units of mJ/cm²). E10 is the energy required to cure a ten mil (254 micron) layer.

*Photo-stability Measurement*

45 g of each sample is added into 60 mL clear jars with a wide open top, available from FlackTek, Inc. The sample containing jars are placed uniformly across an Excella E5 platform shaker available from New Brunswick Scientific Co., Inc. Each sample containing jar is secured with clamps to the platform shaker. The light bank containing two 15 watt plant & aquarium lamps (General Electric, F15T8 PL/AQ) is hung 8 inches high over the shaker platform. The shaker speed is set to 240 rpm. The samples are exposed right under the lamps and rotated daily until the liquid sample is gelled. The liquid sample is gelled when a solid layer has formed on the surface of the liquid sample. The gel time is collected to the nearest hour.

*Thermal-stability Measurement*

After the liquid radiation curable resin is made, it is allowed to sit for between 30 and 60 minutes or until it is degassed. Light tapping of the container holding the liquid radiation curable resin is performed to accelerate the degassing process. The initial viscosity is then measured using a Rheometer from Paar Physica (Rheolab, MC10, Z3 cup and 1/50s shear rate). The samples are held in the machine at the specified shear rate for 15 minutes before data is collected.

45 g of each sample is added into 60 mL clear jars with a wide open top available from FlackTek, Inc. The jar is capped loosely. The sample containing jars are placed in a 55 °C oven for a specified number of days. The samples containing jars are removed from the oven and allowed to cool to ambient conditions. The samples are then remixed and the viscosity is measured using the same equipment and technique mentioned above.

The percentage change in viscosity is calculated by dividing the viscosity at a specified day by the initial viscosity. The result is then multiplied by 100.

**TABLE 4**

| **Component** | **Comp 8** | **Ex 8** | **Comp 9** | **Ex 9** | **Comp 10** | **Ex 10** | **Ex 11** |
|---|---|---|---|---|---|---|---|
| Nanopox A610 | 33.62 | 33.62 | 34.61 | 34.78 | 33.57 | 33.57 | 34.72 |
| Heloxy 68 | 5.71 | 5.71 | 5.88 | 5.91 | 5.70 | 5.70 | 5.89 |
| OXT-101 | 3.81 | 3.81 | 3.92 | 3.94 | 3.80 | 3.80 | 3.93 |
| SR-399LV | 3.42 | 3.42 | 3.52 | 3.54 | 3.42 | 3.42 | 3.54 |
| SR-833S | 2.29 | 2.29 | 2.36 | 2.37 | 2.29 | 2.29 | 2.39 |
| Chivacure 1176 | 3.80 | | 1.00 | | 3.80 | | |
| Irgacure PAG-290 | | 1.90 | | 0.50 | | 1.90 | 0.50 |
| Propylene carbonate | | 1.90 | | | | 1.90 | |
| Irgacure 184 | 0.40 | 0.40 | 0.40 | 0.40 | 0.40 | 0.40 | 0.40 |
| Sunspacer 4.0X-ST-3 | 46.93 | 46.93 | 48.29 | 48.54 | 46.85 | 46.85 | 48.46 |
| HQMME | 0.02 | 0.02 | 0.02 | 0.02 | 0.02 | 0.02 | 0.02 |
| DG-0071 | | | | | 0.15 | 0.15 | 0.15 |
| Total | 100.00 | 100.00 | 100.00 | 100.00 | 100.00 | 100.00 | 100.00 |
| Total fillers | 60.38 | 60.38 | 62.13 | 62.45 | 60.28 | 60.28 | 62.35 |
| Ec (mJ/cm2) | 8.36 | 6.88 | 17.36 | 6.51 | 6.83 | 5.51 | 12.45 |
| Dp (mils) | 4.90 | 1.73 | 14.82 | 3.92 | 4.38 | 1.37 | 5.12 |
| E10 (mJ/cm2) | 64.29 | 2209 | 34.09 | 83.41 | 66.78 | 8177 | 87.75 |
| Photo-stability (hrs, gel time) | 69 | 39 | 79 | 55 | 199 | 199 | No gel |
| Initial Viscosity (cps, 30 °C) | 1693 | 1655 | 2014 | 2227 | 1618 | 1468 | 2089 |
| 15 Day Viscosity (cps, 30 °C) | 4249 | 2849 | 4084 | 3529 | 2549 | 2111 | 3120 |
| 15 Day Viscosity increase (%) | 250.97 | 172.15 | 202.78 | 158.46 | 157.54 | 143.80 | 149.35 |
| 24 Day Viscosity (cps, 30°C) | 6642 | 3312 | 5743 | 3917 | 2927 | 2297 | 3388 |
| 24Day Viscosity increase (%) | 392.32 | 200.12 | 285.15 | 175.89 | 180.90 | 156.47 | 162.18 |

| | | | | | | | |
|---|---|---|---|---|---|---|---|
| No gel = the sample did not gel after 300 hours. Comp = comparative example - not to be construed as an example of the invention Ex = example of the invention | | | | | | | |

*Discussion of Results*

Improved reactivity of Examples 1-7 is demonstrated in comparison to Comparative Example 1.

Comparative Example 8 uses a typical amount of a common cationic photoinitiator used in many commercial liquid radiation curable resins for additive fabrication. Consequently, an E10 and Dp that is suitable for an additive fabrication process is achieved.

Example 8 was designed to demonstrate the effects of a direct swap of an R-substituted aromatic thioether triaryl sulfonium tetrakis(pentafluorophenyl) borate cationic photoinitiator for Chivacure 1176. Example 8 shows a very low Dp and very high E10 due to the increased absorbance of the R-substituted aromatic thioether triaryl sulfonium tetrakis(pentafluorophenyl) borate cationic photoinitiator over Chivacure 1176. The Dp is too low and the E10 far too high compared to Comparative Example 8. Example 8 and Comparative Example 8 would thus not perform similarly in an additive fabrication process. Consequently, the photo-stability of Example 8 is less than the photo-stability of Comparative Example 8. However, the thermal-stability of Example 8 is greatly improved over the thermal-stability of Comparative Example 8.

Example 9 and Comparative Example 9 use a much lower amount of cationic photoinitiator. Again, the Dp is significantly lower than in Comparative Example 8. The reduced amount of cationic photoinitiators in Example 9 and Comparative Example 9 yield additional improvement in the thermal-stability of the liquid radiation curable resin over Example 8 and Comparative Example 8, respectively.

A stabilizer is added in Example 10, Example 11, and Comparative Example 10. The stabilizer greatly improves the photo-stability of the liquid radiation curable resin for additive fabrication. Despite the very low Dp and high E10, Example 10 is able to achieve a photo-stability that is similar to Comparative Example 10 which has a much more desirable Dp and E10. Example 11 demonstrates a Dp that is comparable to Example 8 and a greatly improved photo-stability over any other example or Comparative Example. Example 10 and Example 11 also demonstrate improved thermal-stability over Comparative Example 10.

The use of the terms "a" and "an" and "the" and similar referents in the context of describing the invention (especially in the context of the following claims) are to be construed to cover both the singular and the plural, unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the invention as defined by the appended claims.

Preferred embodiments of this invention are described herein, including the best mode known to the inventors for carrying out the invention as defined by the appended claims. Variations of those preferred embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention is defined in the claims appended hereto.

While the invention has been described in detail and with reference to specific embodiments thereof, it will be apparent to one of ordinary skill in the art that various changes and modifications can be made therein without departing from the scope of the claimed invention.

## Claims

1. A liquid radiation curable resin composition for additive fabrication comprising:
a) an R-substituted aromatic thioether triaryl sulfonium tetrakis(pentafluorophenyl) borate cationic photoinitiator with a tetrakis(pentafluorophenyl)borate anion and a cation of the following formula (1): 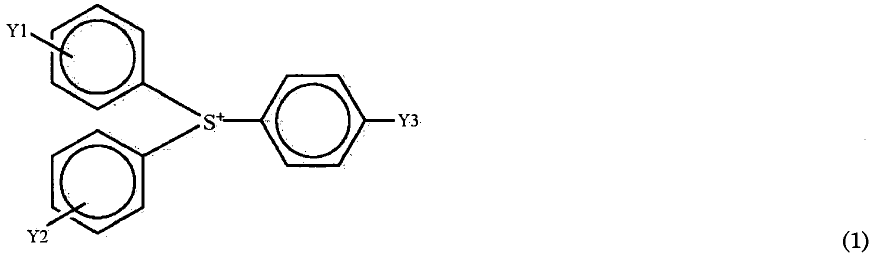 wherein Y1, Y2, and Y3 are the same or different and wherein Y1, Y2, or Y3 are R-substituted aromatic thioether with R being an acetyl group and
b) silica nanoparticles comprising at least 80 wt% silica, preferably 90 wt% silica, more preferably 95 wt% silica.

2. The liquid radiation curable resin composition for additive fabrication of claim 1 wherein the R-substituted aromatic thioether triaryl sulfonium tetrakis(pentafluorophenyl) borate cationic photoinitiator is present in an amount from 0.1 wt% to 20 wt%, preferably from 0.1 wt% to 10 wt%, more preferably from 0.1 wt% to 7 wt%, more preferably from 0.2 wt% to 4 wt% of the liquid radiation curable resin composition for additive fabrication.

3. The liquid radiation curable resin composition for additive fabrication of claim 2 further comprising:
a. from 2 to 40 wt% of a radically polymerizable compound
b. from 10 to 80 wt% of a cationically polymerizable compound and
c. from 0.1 to 10 wt% of a radical photoinitiator

4. The liquid radiation curable resin composition for additive fabrication of any one of claims 1-3 wherein Y1, Y2, and Y3 are the same.

5. The liquid radiation curable resin composition for additive fabrication of any one of claims 1-4 wherein the R-substituted aromatic thioether triaryl sulfonium tetrakis(pentafluorophenyl) borate cationic photoinitiator is tris(4-(4-acetylphenylthio)phenyl)sulfonium tetrakis(pentafluorophenyl)borate.

6. The liquid radiation curable resin composition for additive fabrication of any one of claims 1-5 wherein the R-substituted aromatic thioether triaryl sulfonium tetrakis(pentafluorophenyl) borate cationic photoinitiator is present in an amount from 0.1 wt% to 2 wt%.

7. The liquid radiation curable resin composition for additive fabrication of any one of claims 1-6 further comprising a cationic photoinitiator that is not an R-substituted aromatic thioether triaryl sulfonium tetrakis(pentafluorophenyl) borate cationic photoinitiator.

8. The liquid radiation curable resin composition for additive fabrication of any one of claims 1-7 further comprising a photosensitizer.

9. The liquid radiation curable resin composition for additive fabrication of any one of claims 1-8 wherein the silica nanoparticles are present in an amount from 5 wt% to 90 wt%, preferably from 10 wt% to 75 wt%, more preferably from 30 wt% to 75 wt% of the liquid radiation curable resin composition for additive fabrication.

10. The liquid radiation curable resin composition for additive fabrication of any one of claims 1-9 further comprising from 0.1 to 1 wt% of a stabilizer.

11. The liquid radiation curable resin for additive fabrication of claim 10 wherein the stabilizer is a liquid Na₂CO₃ solution.

12. A process of forming a three-dimensional object comprising the steps of forming and selectively curing a layer of the liquid radiation curable resin composition for additive fabrication of any one of claims 1-11 with actinic radiation and repeating the steps of forming and selectively curing a layer of the liquid radiation curable resin composition for additive fabrication of any one of claims 1-11 a plurality of times to obtain a three dimensional object.

13. The process of claim 12 wherein the source of actinic radiation is one or more LEDs, wherein the one or more LEDs preferably emit light at a wavelength of 200 nm - 460 nm, more preferably from 300 nm - 400 nm, more preferably from 340 nm to 370 nm, more preferably having a peak at 365 nm.

14. A three-dimensional object obtainable from the liquid radiation curable resin composition of any one of claims 1-11 or by the process of any one of claims 12-13.

## Patentansprüche

1. Flüssige strahlungshärtbare Harzzusammensetzung zur Additivherstellung, enthaltend:
a) einen R-substituierten aromatischen kationischen Thioethertriarylsulfoniumtetrakis(pentafluorphenyl)borat Fotoinitiator mit einem Tetrakis(pentafluorphenyl)borat Anion und einem Kation der folgenden Formel (1): 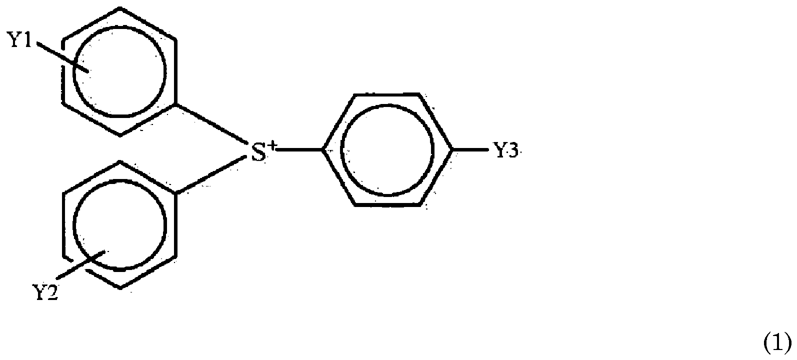 wobei Y1, Y2 und Y3 gleich oder verschieden sind und wobei Y1, Y2 oder Y3 R-substituierte aromatische Thioether sind, wobei R eine Acetylgruppe ist, und
b) Silicananopartikel, enthaltend mindestens 80 Gew. % Silica, vorzugsweise 90 Gew. % Silica, bevorzugter 95 Gew. % Silica.

2. Flüssige strahlungshärtbare Harzzusammensetzung zur Additivherstellung nach Anspruch 1, wobei der R-substituierte aromatische kationische Thioethertriarylsulfoniumtetrakis(pentafluorphenyl)borat Fotoinitiator in einer Menge von 0,1 Gew. % bis 20 Gew. %, vorzugsweise von 0,1 Gew. % bis 10 Gew. %, bevorzugter von 0,1 Gew. % bis 7 Gew. %, bevorzugter von 0,2 Gew. % bis 4 Gew. % der flüssigen strahlungshärtbaren Harzzusammensetzung zur Additivherstellung anwesend ist.

3. Flüssige strahlungshärtbare Harzzusammensetzung zur Additivherstellung nach Anspruch 2, ferner enthaltend:
a) von 2 bis 40 Gew. % einer radikal polymerisierbaren Zusammensetzung
b) von 10 bis 80 Gew. % einer kationisch polymerisierbaren Zusammensetzung und
c) von 0,1 bis 10 Gew. % eines radikalen Fotoinitiators.

4. Flüssige strahlungshärtbare Harzzusammensetzung zur Additivherstellung nach einem der Ansprüche 1-3, wobei Y1, Y2 und Y3 gleich sind.

5. Flüssige strahlungshärtbare Harzzusammensetzung zur Additivherstellung nach einem der Ansprüche 1-4, wobei der R-substituierte aromatische kationische Thioethertriarylsulfoniumtetrakis(pentafluorphenyl)borat Fotoinitiator Tris(4-(4-acetylphenylthio)phenyl)sulfoniumtetrakis(pentafluorphenyl)borat ist.

6. Flüssige strahlungshärtbare Harzzusammensetzung zur Additivherstellung nach einem der Ansprüche 1-5, wobei der R-substituierte aromatische kationische Thioethertriarylsulfoniumtetrakis(pentafluorphenyl)borat Fotoinitiator in einer Menge von 0,1 Gew. % bis 2 Gew. % anwesend ist.

7. Flüssige strahlungshärtbare Harzzusammensetzung zur Additivherstellung nach einem der Ansprüche 1-6, ferner enthaltend einen kationischen Fotoinitiator, der kein R-substituierter aromatischer kationischer Thioethertriarylsulfoniumtetrakis(pentafluorphenyl)borat Fotoinitiator ist.

8. Flüssige strahlungshärtbare Harzzusammensetzung zur Additivherstellung nach einem der Ansprüche 1-7, ferner enthaltend einen Fotosensibilisator.

9. Flüssige strahlungshärtbare Harzzusammensetzung zur Additivherstellung nach einem der Ansprüche 1-8, wobei die Silicananopartikel in einer Menge von 5 Gew. % bis 90 Gew. %, vorzugsweise von 10 Gew. % bis 75 Gew. %, bevorzugter von 30 Gew. % bis 75 Gew. % der flüssigen strahlungshärtbaren Harzzusammensetzung zur Additivherstellung anwesend sind.

10. Flüssige strahlungshärtbare Harzzusammensetzung zur Additivherstellung nach einem der Ansprüche 1-9, ferner enthaltend von 0,1 bis 1 Gew. % eines Stabilisators.

11. Flüssige strahlungshärtbare Harzzusammensetzung zur Additivherstellung nach Anspruch 10, wobei der Stabilisator eine flüssige Na₂CO₂-Lösung ist.

12. Verfahren zur Bildung eines dreidimensionalen Objekts, umfassend die Schritte des Bildens und selektiven Härtens einer Schicht der flüssigen strahlungshärtbaren Harzzusammensetzung zur Additivherstellung nach einem der Ansprüche 1-11 mit aktinischer Strahlung und mehrmaliges Wiederholen der Schritte des Bildens und selektiven Härtens einer Schicht der flüssigen strahlungshärtbaren Harzzusammensetzung zur Additivherstellung nach einem der Ansprüche 1-11, um ein dreidimensionales Objekt zu erhalten.

13. Verfahren nach Anspruch 12, wobei es sich bei der Quelle der aktinischen Strahlung um eine oder mehr LEDs handelt, wobei die eine oder mehr LEDs Licht mit einer Wellenlänge von 200 nm - 460 nm, bevorzugter von 300 nm - 400 nm, bevorzugter von 340 nm bis 370 nm, bevorzugter mit einer Spitze bei 365 nm, emittieren.

14. Dreidimensionales Objekt, erhältlich von der flüssigen strahlungshärtbaren Harzzusammensetzung nach einem der Ansprüche 1-11 oder durch das Verfahren nach einem der Ansprüche 12-13.

## Revendications

1. Composition de résine durcissable par rayonnement liquide pour une fabrication additive comprenant :
a) un photoinitiateur cationique tétrakis(pentafluorophényl)-borate de thioéther aromatique R-substitué triarylsulfonium avec un anion tétrakis(pentafluorophényl)borate et un cation de formule (1) suivante : 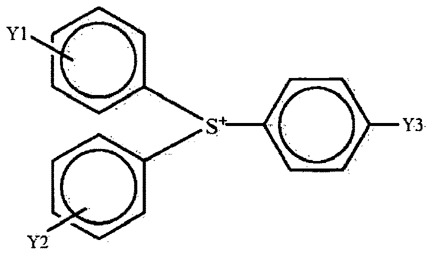 où Y1, Y2 et Y3 sont identiques ou différents et où Y1, Y2 ou Y3 sont un thioéther aromatique R-substitué, R étant un groupe acétyle et
b) des nanoparticules de silice comprenant au moins 80 % en poids de silice, de préférence 90 % en poids de silice, de préférence encore 95 % en poids de silice.

2. Composition de résine durcissable par rayonnement liquide pour une fabrication additive selon la revendication 1 où le photoinitiateur cationique tétrakis(pentafluorophényl)borate de thioéther aromatique R-substitué triarylsulfonium est présent en une quantité de 0,1 % en poids à 20 % en poids, de préférence de 0,1 % en poids à 10 % en poids, de préférence encore de 0,1 % en poids à 7 % en poids, de préférence encore de 0,2 % en poids à 4 % en poids de la composition de résine durcissable par rayonnement liquide pour une fabrication additive.

3. Composition de résine durcissable par rayonnement liquide pour une fabrication additive selon la revendication 2 comprenant en outre :
a. de 2 à 40 % en poids d'un composé polymérisable par polymérisation radicalaire
b. de 10 à 80 % en poids d'un composé polymérisable par polymérisation cationique et
c. de 0,1 à 10 % en poids d'un photoinitiateur radicalaire.

4. Composition de résine durcissable par rayonnement liquide pour une fabrication additive selon l'une quelconque des revendications 1-3 où Y1, Y2 et Y3 sont identiques.

5. Composition de résine durcissable par rayonnement liquide pour une fabrication additive selon l'une quelconque des revendications 1-4 où le photoinitiateur cationique tétrakis(pentafluorophényl)borate de thioéther aromatique R-substitué triarylsulfonium est le tétrakis-(pentafluorophényl)borate de tris(4-(4-acétylphénylthio)phényl)sulfonium.

6. Composition de résine durcissable par rayonnement liquide pour une fabrication additive selon l'une quelconque des revendications 1-5 où le photoinitiateur cationique tétrakis(pentafluorophényl)borate de thioéther aromatique R-substitué triarylsulfonium est présent en une quantité de 0,1 % en poids à 2 % en poids.

7. Composition de résine durcissable par rayonnement liquide pour une fabrication additive selon l'une quelconque des revendications 1-6 comprenant en outre un photoinitiateur cationique qui n'est pas un photoinitiateur cationique tétrakis(pentafluorophényl)borate de thioéther aromatique R-substitué triarylsulfonium.

8. Composition de résine durcissable par rayonnement liquide pour une fabrication additive selon l'une quelconque des revendications 1-7 comprenant en outre un photosensibilisateur.

9. Composition de résine durcissable par rayonnement liquide pour une fabrication additive selon l'une quelconque des revendications 1 -8 où les nanoparticules de silice sont présentes en une quantité de 5 % en poids à 90 % en poids, de préférence de 10 % en poids à 75 % en poids, de préférence encore de 30 % en poids à 75 % en poids de la composition de résine durcissable par rayonnement liquide pour une fabrication additive.

10. Composition de résine durcissable par rayonnement liquide pour une fabrication additive selon l'une quelconque des revendications 1-9 comprenant en outre de 0,1 à 1 % en poids d'un stabilisant.

11. Résine durcissable par rayonnement liquide pour une fabrication additive selon la revendication 10 où le stabilisant est une solution de Na₂CO₃ liquide.

12. Procédé de formation d'un objet tridimensionnel comprenant les étapes de formation et de durcissement sélectivement d'une couche de la composition de résine durcissable par rayonnement liquide pour une fabrication additive selon l'une quelconque des revendications 1-11 avec un rayonnement actinique et de répétition des étapes de formation et de durcissement sélectivement d'une couche de la composition de résine durcissable par rayonnement liquide pour une fabrication additive selon l'une quelconque des revendications 1-11 une pluralité de fois pour obtenir un objet tridimensionnel.

13. Procédé selon la revendication 12 où la source de rayonnement actinique est une ou plusieurs DEL, où la une ou plusieurs DEL émettent de préférence de la lumière à une longueur d'onde de 200 nm - 460 nm, de préférence encore de 300 nm - 400 nm, de préférence encore de 340 nm à 370 nm, de préférence encore ayant un pic à 365 nm.

14. Objet tridimensionnel pouvant être obtenu à partir de la composition de résine durcissable par rayonnement liquide selon l'une quelconque des revendications 1-11 ou par le procédé selon l'une quelconque des revendications 12-13.
